Europäisches Patentamt

European Patent Office

Office européen des brevets

(11) Publication number: **0 209 795**
**A2**

## EUROPEAN PATENT APPLICATION

(21) Application number: **86109371.4**

(22) Date of filing: **09.07.86**

(51) Int. Cl.⁴: **G 06 F 15/60**

(30) Priority: **22.07.85 US 757840**

(43) Date of publication of application:
**28.01.87 Bulletin 87/5**

(84) Designated Contracting States:
**BE CH FR GB IT LI SE**

(71) Applicant: **WESTINGHOUSE ELECTRIC CORPORATION**
**Westinghouse Building Gateway Center**
**Pittsburgh Pennsylvania 15222(US)**

(72) Inventor: **Cook, Bruce Michael**
**425 Tivoli Road**
**Pittsburgh Pennsylvania 15239(US)**

(72) Inventor: **Gutman, Jerzy**
**758 Bar Harbor Drive**
**Pittsburgh Pennsylvania 15239(US)**

(74) Representative: **Modiano, Guido et al,**
**MODIANO, JOSIF, PISANTY & STAUB Modiano &**
**Associati Via Meravigli, 16**
**I-20123 Milan(IT)**

(54) A method of creating and executing table driven logic.

(57) The present invention is directed to a method of creating and executing a logic driven table comprising entering mnemonics corresponding to signals in the system, creating a logic table from the entered mnemonics, verifying the accuracy of the logic table and executing the logic design of the table using actual input signals to produce actual output control signals. During the execution of the logic table the input signals are overlayed on the mnemonics of the table and a Boolean logic equation for a basic logic element is executed for each stage within each totem in the table. The execution of the equation is repeated until all input signals and the effects of the input signals have propagated through the table.

FIG. 2.

EP 0 209 795 A2

1

# A METHOD OF CREATING AND EXECUTING TABLE DRIVEN LOGIC

## BACKGROUND OF THE INVENTION

### Field of the Invention

The present invention generally relates to a computer aided method for the design of a logic system such as the actuation logic for engineered safeguard functions in a nuclear power plant and to the execution of the logic for the system as table driven logic, and more particularly, the present invention includes a method of expressing a logic function in the form of a table representing a logic array constructed of one or more basic building blocks, where the table clearly defines the prioritization of actuation and interlock input signals, can be generated directly from a precise verbal description of a given device or system where the contents of the table are input into a microcomputer and executed using a universal table driven logic execution routine.

### Description of the Related Art

In a nuclear power plant, engineered safeguard functions consist of actions to be taken to mitigate damage and ensure safety under abnormal or emergency conditions. These actions may be initiated manually, by means of pushbuttons or automatically, based on inputs from sensors which can transmit information concerning process variables and the states of actuated devices such as valves and pumps. To control those actuated devices which are necessary to implement the desired safeguard functions, these sensor inputs are processed by redundant logic networks which generate outputs through a power interface to energize or de-energize the proper devices in the proper sequences subject to any required enabling or interlock signals.

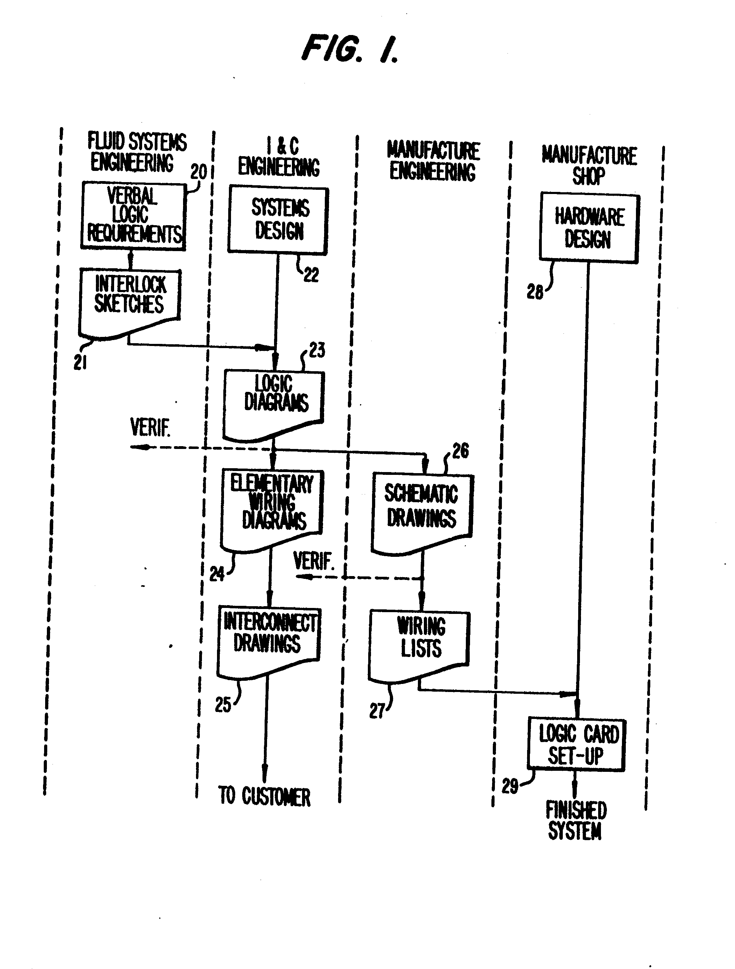

In all cases relating to a nuclear power plant, the design of the logic network begins with a fluid systems engineer who reduces the desired safeguard action to a sequence of operations of various fluid control devices such as the valves and pumps. The operation of these devices must be made subject to various interlock signals based on parameters such as pressure or the present state of the actuated devices. A verbal logic statement which accounts for each input, interlock and output signal is generated by the engineer, as illustrated in Fig. 1, for each actuated device. The engineer then transposes these requirements into the form of a logic or interlock sketch. Once the logic sketch is completed, the verbal requirements produced by the systems engineer are unnecessary. The fluid systems engineer forwards the interlock sketch to an instrumentation and control engineer who develops a logic diagram, adds provisions for status indication and power interface circuitry and develops interconnection drawings in the form of interposing logic power interface and elementary wiring diagrams. The design is further refined by a manufacturing engineer who develops schematics geared to the specific hardware to be used to implement the circuit, designs a hardware circuit that is functionally equivalent to the logic diagram and creates detailed wiring lists which are used by a manufacturing group to construct a final embodiment of the logic. At various stages in the process, the design may be checked by sending the work product back to the previous engineering stage for verification. The overall design is then validated by system testing.

## SUMMARY OF THE INVENTION

The present invention lowers the cost of the development of logic networks, removes unnecessary developmental stages during the development of the logic network, substitutes software for hardwired logic, increases the viability of system designs, removes points of human created error, and is directed to a method of creating and executing a logic driven table comprising entering the mnemonics corresponding to signals in the system, creating a logic table from the entered mnemonics, verifying the accuracy of the logic table and executing the logic table using actual input signals to produce actual output control signals.

The invention in its broad form comprises a method of creating and executing table driven logic for a logic system having input signals, characterized by the steps of: (a) entering mnemonics corresponding to signals in the system; (b) creating a logic table (20) from the entered mnemonics using at least AND, OR and NOT operations; (c) verifying the logic table for its accuracy; and (d) executing the logic defined by the logic table using the input signals to produce output signals.

## BRIEF DESCRIPTION OF THE DRAWINGS

A more detailed understanding of the invention may be had from the following description of a preferred embodiment, given by way of example and to be understood in conjunction with the accompanying drawing wherein:

Figure 1 is a diagram of the stages of a prior art hardware design process;

Fig. 2 is a diagram of a design process according to the present invention;

Fig. 3 is a diagram of a basic logic element 10 of the present system;

Fig. 4 is a logic table 20 for the basic logic element 10 of Fig. 3;

Fig. 5 is a totem comprising three basic logic elements 14-16;

Fig. 6 is a logic table 20 for Fig. 5;

Fig. 7(A) is a logic diagram 30 for a latch logic element;

Fig. 7(B) is a simplified logic diagram 30 for a latch logic element;

Fig. 8 is a logic table 20 for the latch of Fig. 7;

Fig. 9 is a bypass valve logic table 20;

Fig. 10 is a logic diagram 30 for the bypass valve of the logic table 20 of Fig. 9;

Fig. 11 is an example of the logic state analysis for the table 20 of Fig. 9;

Fig. 12 is a logic table 20 for a home alarm system;

Fig. 13 is the produced logic diagram 30 for the table 20 of Fig. 12;

Fig. 14 is the logic state analysis of the table 20 of Fig. 12;

Figs. 15-17 depict the stages of the logic table of Fig. 12 during the stages of its processing using actual inputs to produce an output;

Fig. 18, including 18(A)-18(G), is a flowchart of the editor software of the present invention;

Fig. 19, including 19(A)-19(F), is a flowchart of the software which draws the logic diagram;

Fig. 20, including 20(A)-20(E), is a flowchart of the logic analyzer which produces the state analysis for each logic network; and

Fig. 21, including 21(A)-21(B), is an example of a general purpose execution module for executing the logic defined by any logic table.

## DESCRIPTION OF THE PREFERRED EMBODIMENTS

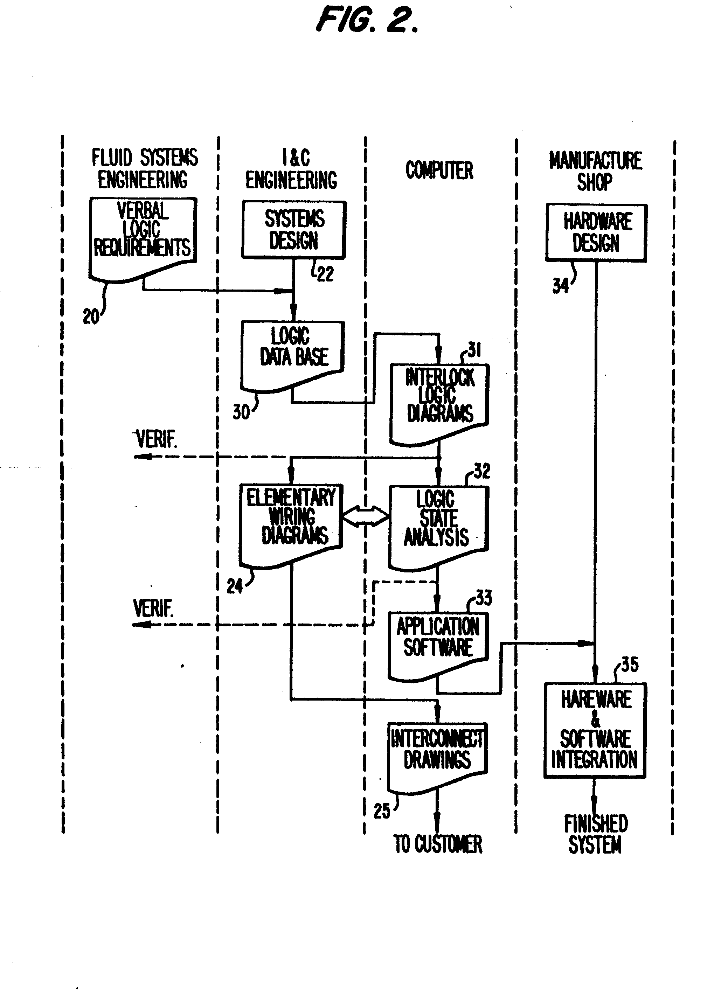

In contrast to the prior art process, the present invention, as illustrated by Fig. 2, permits a verbal logic statement generated by a fluid systems engineer to be entered directly into a computer data base which is then interpreted by the computer to automatically generate logic diagrams, perform a system analysis directed toward identifying unstable states or states from which no combinations of inputs will produce a change in outputs and for producing the logic table. The logic table then can be processed by a general purpose logic table execution routine executed by a conventional microprocessor to produce the necessary outputs from actual inputs.

As can be seen in Fig. 2, the process according to the present invention starts with the verbal logic requirements which are documented by the fluid systems engineer in a natural language form. From the verbal requirements the instrumentation and control engineer generates a data base that can be input into the computer. The data base represents the logic in a standard tabular form. By casting the logic in a standard form, consistency in the design of the entire system is ensured. The computer then automatically produces the logic diagrams and a logic state analysis which are used for design verification. The generated document sets forth the functional operation of the logic and can be easily checked against the verbal logic requirements. The interposing logic power interface and elementary diagrams are generated from which interconnect writing diagrams are prepared. The logic table then can be incorporated into a microprocessor and validated by systems testing. Once validated the logic table can be burned into a ROM and executed by a general purpose microprocessor.

As can be seen by comparing Figs. 1 and 2, significant man-hour savings result from using the present invention for each logic network design.

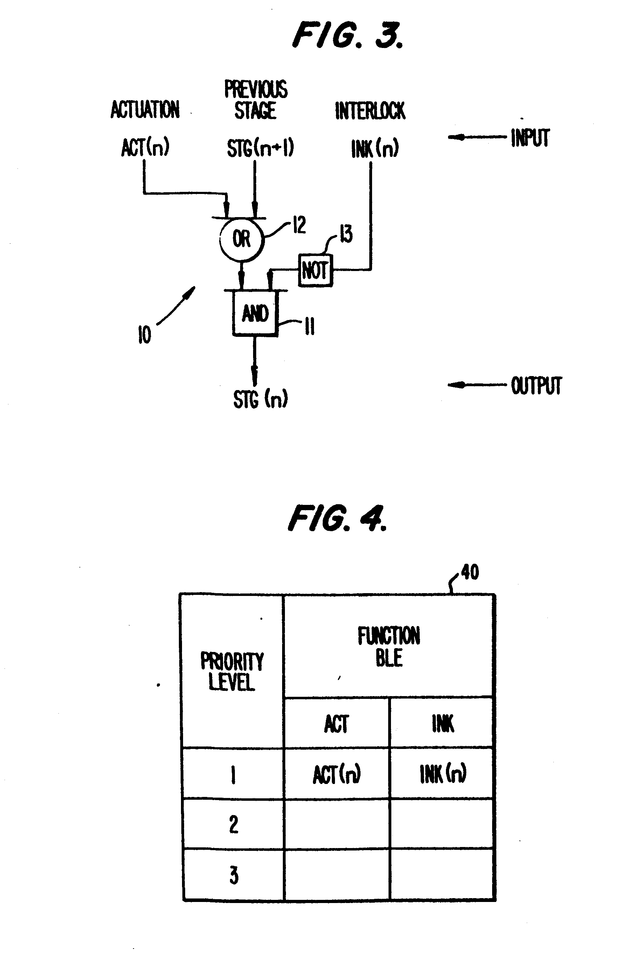

It is well known that any function may be derived from a combination of logic states such as AND, OR and NOT operations. The present invention takes advantage of this known principle and defines a basic logic element 10 which is made up of the three fundamental logic operators as illustrated in Fig. 3. The fundamental logic operators AND 11 , OR 12 and NOT 13 are connected so that an interlock signal (INK) interlocks or prevents an output of both an actuation signal (ACT) and a signal from a previous stage (STG(n+1)) until the interlock signal is removed. The output can be represented in the terms of the inputs by the following Boolean equation:

STG(n) = [NOT INK(n)] AND [ACT(n) OR STG(n+1)].

A logic table 20 for the basic logic element 10 of Fig. 3 is illustrated in Fig. 4. This logic table indicates that the STG(n) function is actuated by the previous stage at a priority level of 2, the actuation signal at a priority level of 1 and is interlocked by INK(n) at priority level 1. The method of creating the logic table of Fig. 4 along with the rules and definitions for creating such a table will be discussed in detail hereinafter.

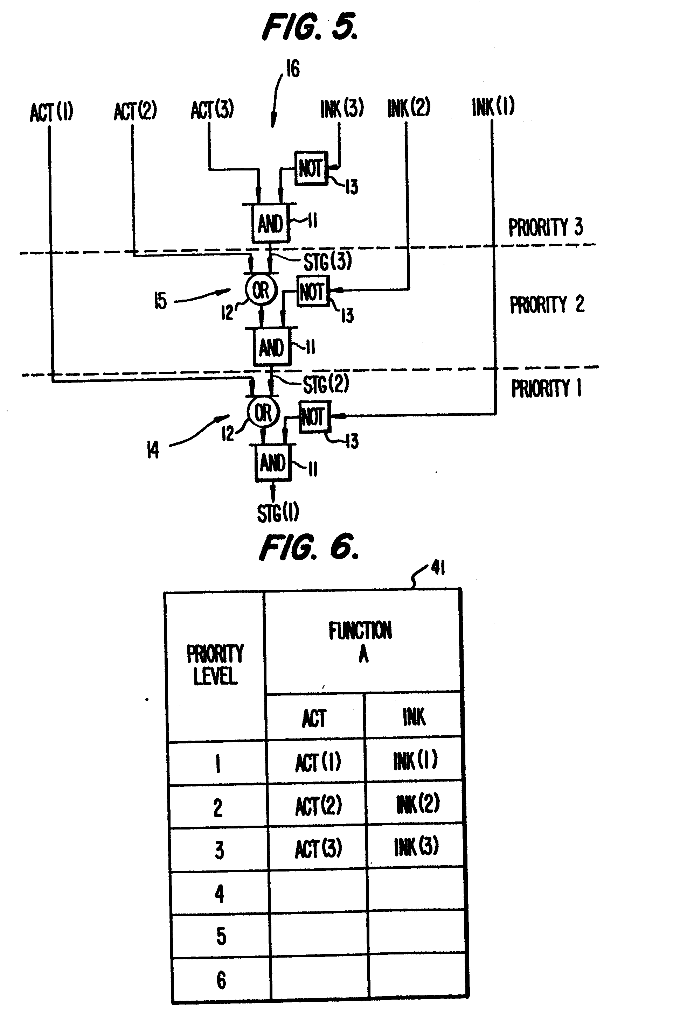

A plurality of the basic logic elements may be connected vertically in a chain to form a totem in which the actuation and interlock signals are assigned priorities as illustrated in Fig. 5, which shows an example of a totem built with three basic logic elements 14, 15 and 16. In this figure stage number can be interpreted as the priority level of the actuating and interlocking signals. Each totem has only one output but any number of totems may be connected to form multiple output functions in which the output of any totem may be used as an input to the actuation or interlock inputs of any other totem. In the single totem example of Fig. 5, the output function STG(1) of the priority 1 totem 14 is actuated by the actuation signals ACT(1) at the first priority level, ACT(2) on the second priority level and ACT(3) on the third priority level. The interlock signal INK(1) locks or interlocks actuation signals ACT(1-3) as well as interlock signals INK(2-3). The interlock signal INK(2) interlocks actuation signals ACT(2-3) and interlock signal INK(3) of the priority 2 totem 15, while the interlock signal INK(3) interlocks at the priority 3 totem 16. The interlock signal INK(1)

represents the highest priority interlocking signal. In general the priority interlock signal interlocks every actuation and interlock signal of lower or equal priority level in the totem. The above statement is used as one of the fundamental rules in constructing logic in the form of totems. Because the output of any totem can be used as an input to any totem on any priority level it is possible to define a totem as an intermediate logic to be used with other totems in the interposing logic. Such an auxiliary logic totem can be used to define a particular mode of operation, for example, an automode or a signal latching function to be discussed later.

Fig. 6 illustrates the logic table 20 for the totem of Fig. 5. As can be seen from Fig. 6 the logic table is constructed starting at the highest priority level and working up the totem to define the actuation and interlock signal positions. The output signal from each higher stage is implied as an input to the next stage because the totem has more than one priority level.

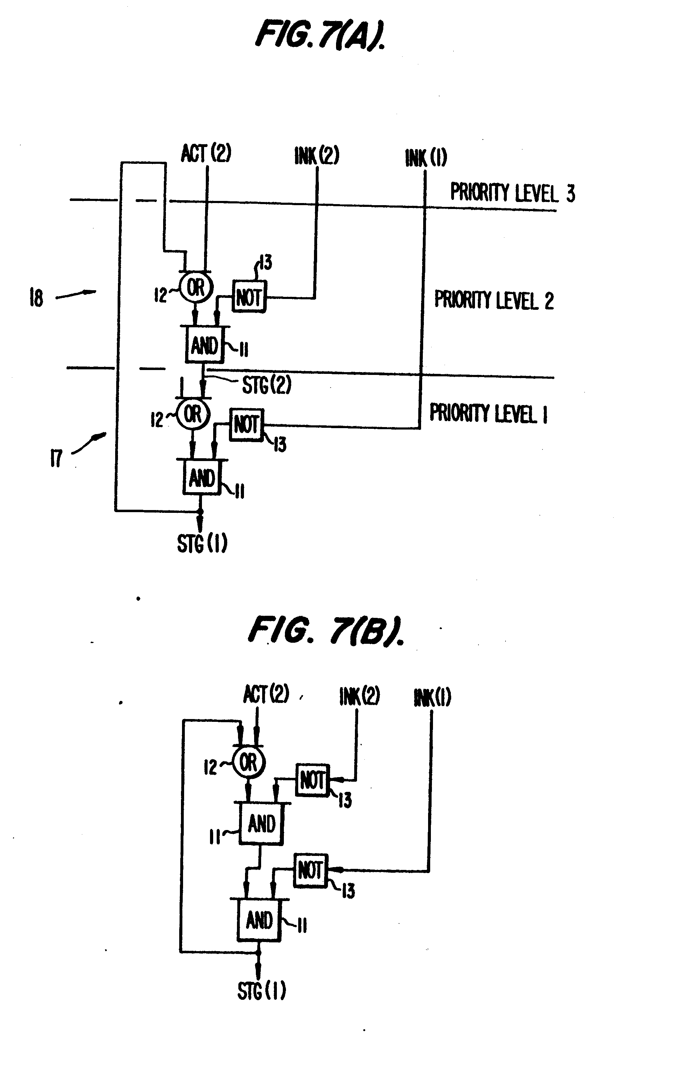

A latch is created when the output of the totem is entered as one of its own actuations, as illustrated in Fig. 7(A). The latch consists of two basic elements 17 and 18 and includes three priority levels or stages. The output of stage 1 is fed back to the token at priority level or stage 3. The latch is set by the actuation signal ACT(2) and reset by interlock signal INK(1) or the interlock INK(2). The actuation signal input of stage 1 is not used. Fig. 7(B) illustrates a simplified version of Fig. 7(A). The latch must be in the lowest position in the totem and no combinatorial logic can be allowed below the latch, however, the output of the latch can be used as an input into another totem if logic after the latch is necessary.

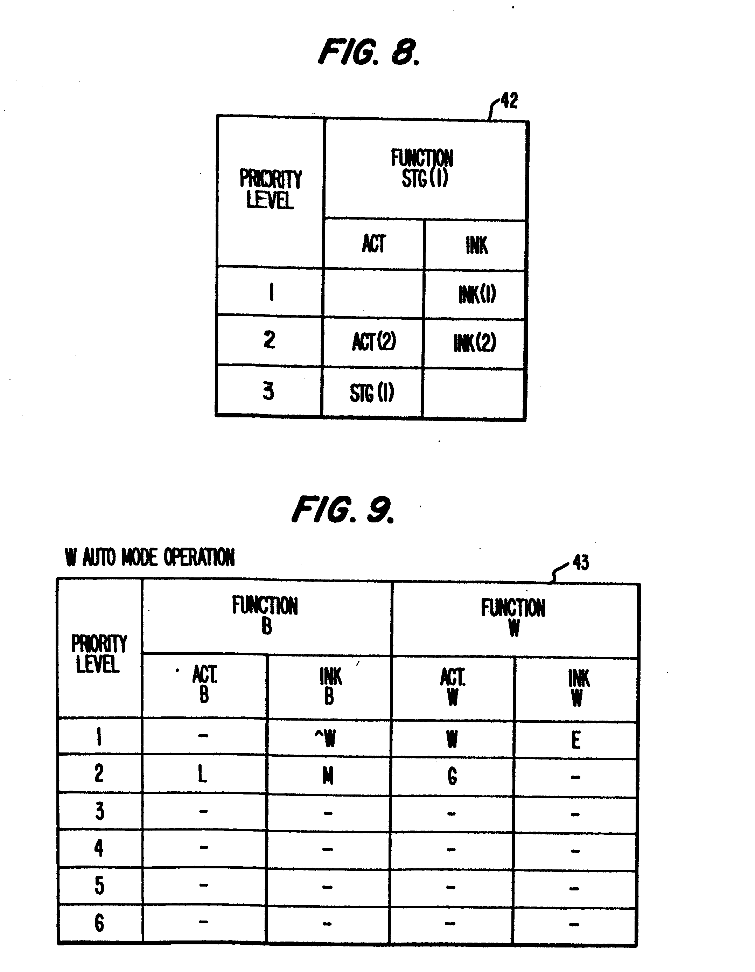

Fig. 8 illustrates the logic table 20 for the latch of Fig. 7. As can be therein seen the third priority or stage input signal on the actuation side is the output of the STG(1) latch and the output of the latch is interlocked by interlock signal INK(1) at priority level 1 (stage level 1) and by the interlock signal INK(2) at the second stage or second priority level. Once again it should be self evident that the logic table is created from bottom (highest priority) to top (lowest priority) of the totem. That is, first the input signals to the first stage are examined and found to be the interlock signal INK(1) and the next highest stage output STG(2). Since the next highest stage input is implied no entry is necessary, however, an entry could be made in the table at priority level 1 on the ACT side. If the entry is made it would be equivalent to having both inputs to the OR gate of basic logic element 17 receiving the output from STG(2). Next the input signals to stage 2 are examined and found to be INK(2), ACT(2) and STG(1). Because the STG(1) signal is acting as a STG(3) signal, it must be entered on the next highest priority or stage level number 3.

In constructing the logic tables from a complete verbal description of the required logic the following rules and definitions must be followed:

1. Each defined function must either be actuated or interlocked (or both) on the first priority level. That is, the table must have an entry on the first line for any given function.

2. A function cannot be actuated and interlocked by the same signal at the same time.

3. A function cannot be actuated or interlocked by the same signal on two different priority levels, although the same input signal can be shared between different functions.

4. The priority of the last interlock in a function must be higher than the priority of the last actuation in this function.

5. Each signal used in the table must have a definition and each defined signal must be used in the table, there shall be a one-to-one correspondence between the table and definitions, and no multiple definitions of signals are permitted.

6. The symbol "⋀" in front of a signal in a table indicates a logical NOT operation to be performed on the signal following the operator.

7. The symbol "." in front of a function name indicates a delay is to be performed on this function where the delay time period must be specified when the function is defined.

8. A function can be used as one of its own actuations (example: a latching function) or as an input (either an actuation or interlock) in other functions.

9. If a function is to be used as intermediate logic it should be defined as an auxiliary function not as an output function.

As a first example of the creation of the logic table and execution thereof we will consider a boron thermal regeneration system bypass valve. In general the regeneration system has three operating modes: off, dilute and borate. The operating mode is determined either manually by the operator positioning an MCB control switch or automatically by the power control system. When in automatic, the regeneration system is always operating in either dilute or borate mode which provides faster response and reduces the start and stop transients in the system. The bypass valve diverts water into the regeneration system. The fluid systems engineer provides the following description to the instrumentation and control engineer:

The valve is operated by two pushbuttons, auto and open, the regeneration system "dilute or borate" automatic signal and the status of an isolation valve. There is one solenoid valve and the solenoid shall be energized to close the valve and de-energized to open it. The auto pushbutton activates an auto operation mode. When in the automode:

1.  When the dilute or borate signal is in coincidence with the open position of the isolation valve (a limit switch signal exists) the bypass valve is closed (solenoid is energized).

2.  When the open pushbutton is activated the valve is opened (the solenoid is de-energized) by changing the mode of operation to manual. The automode is reset by open pushbutton.

When in manual mode the valve is always open.

From the above verbal description, the instrumentation and control engineer generates a logic data base and inputs same into the computer in the form of the logic table 20 of Fig. 9 which corresponds directly to the verbal description above. In the example, automode is defined as an auxiliary function W and the closed valve command as an output signal of function B, therefore there are two totems describing the lock logic and therefore two functions in the totem. In the table, the input signal E represents the open pushbutton, G the auto pushbutton, L the dilute or borate signal and M the closed isolation valve signal.

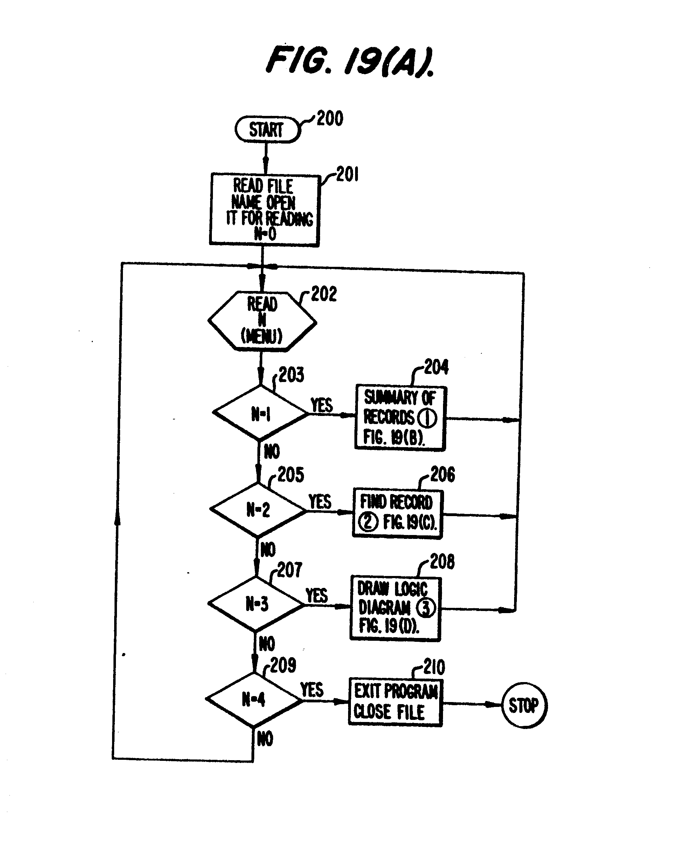

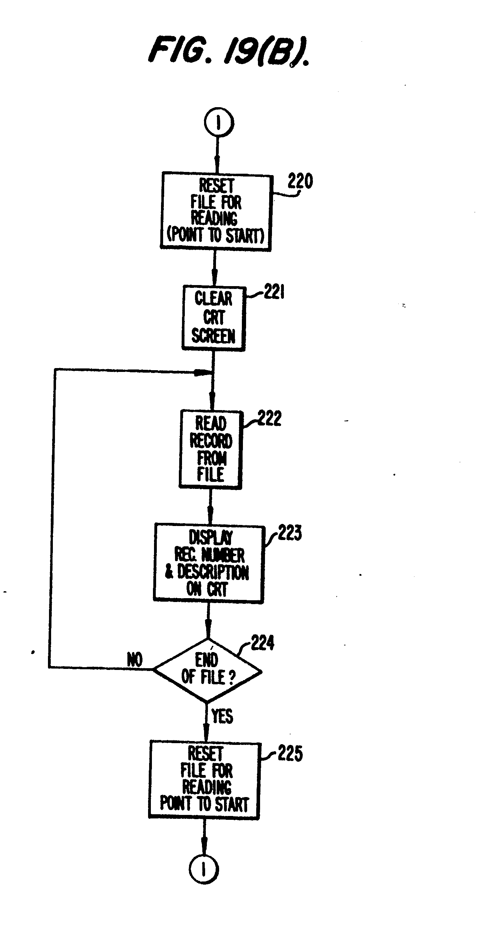

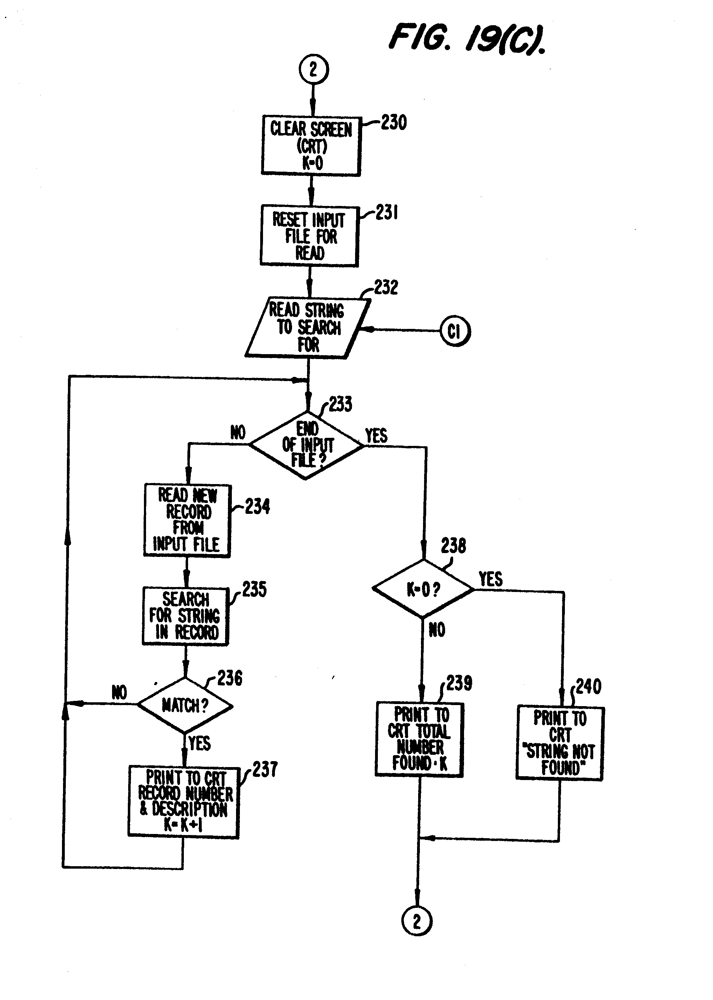

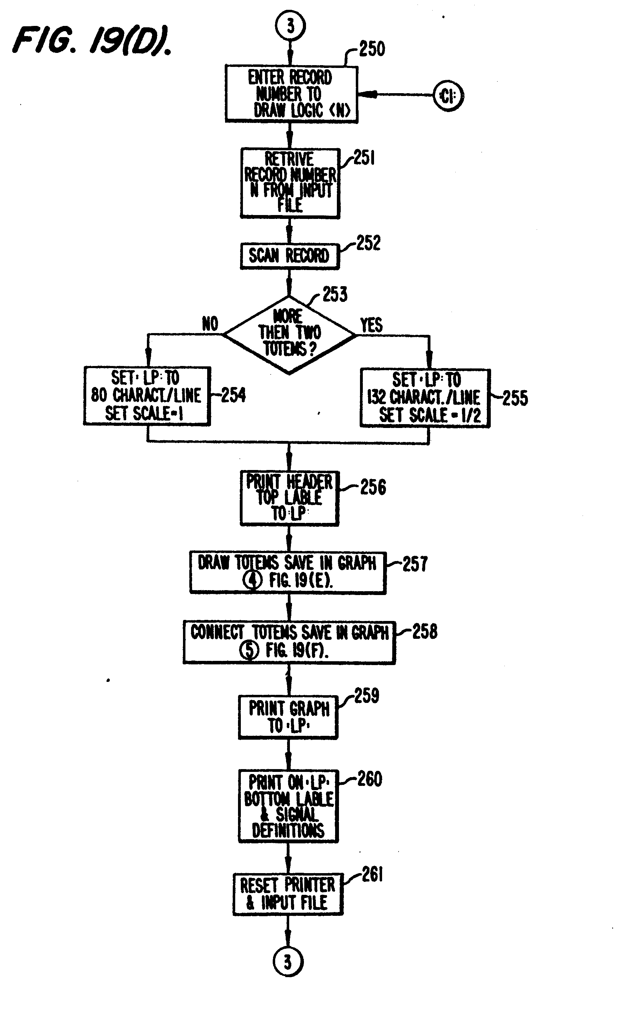

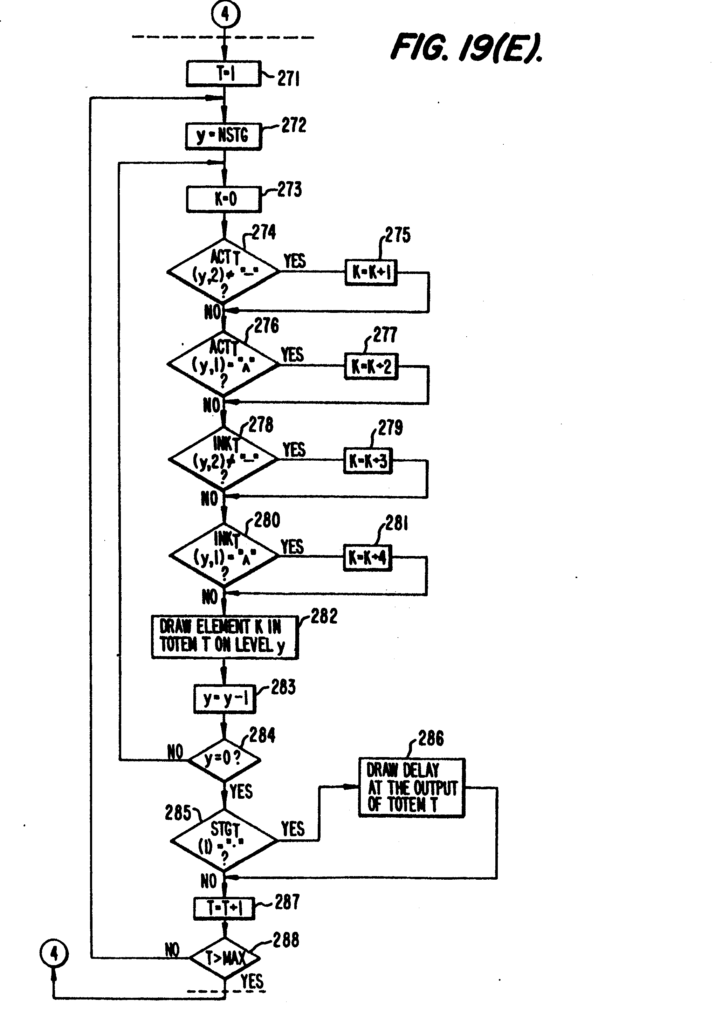

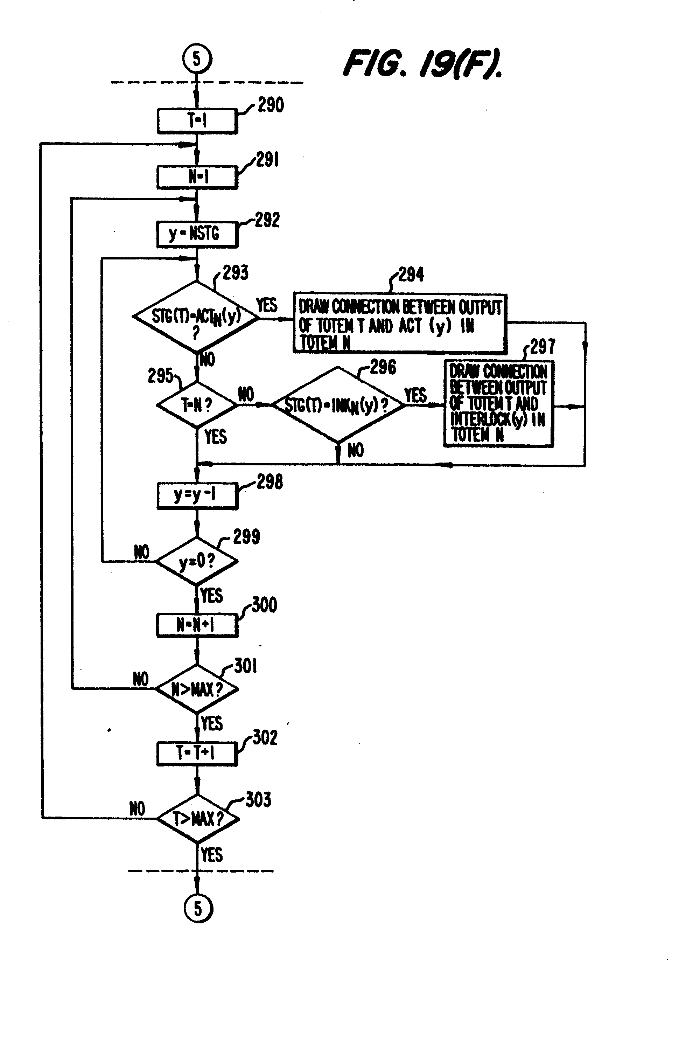

The logic table and a corresponding data record is created using the editor program illustrated in Fig. 19. The data record created would look as follows:

```
01 8245
02    1 BORON THERMAL REGENERATION SYSTEM (BTRS)
03 BTRS bypass valve
04 AOV N/A Non Safety NO  NO OPEN (dwg. number)
05 E OPEN PUSHBUTTON
05 G AUTO PUSHBUTTON
05 L DILUTE OR BORATE SIGNAL
05 M VALVE 7054 CLOSED (33bo)
06 B CLOSE VALVE
07 W AUTO MODE OPERATION
08 B - B ---- W M ----
08 W G W ---- E -----
09 1 . OPEN VALVE 8245 ON LOSS OF POWER
09     (DE-ENERGIZE SOLENOID TO OPEN)
10 EOF NO. 1
```

In this record line 01 corresponds to the component I.D. number, lines 02 through 04 represent the component's description. Lines numbered 05 provide the definitions of the input signals (there are four lines with the number 05), line 06 defines an output signal and line 07 defines an auxiliary function. The logic Table is described by lines 08. There are two lines in the logic Table corresponding to two logic totems defined by lines 06 and 07 (output and auxiliary function). The record is automatically verified by the computer against the set of rules previously discussed. The format of the record is verified rather than a logic itself. If an error is detected, the record must be corrected before it is stored on the disc. Line 09 (up to five lines fifty characters long each can be used) is provided for special notes. Line 10 marks the end of record. Each record represents information about one component.

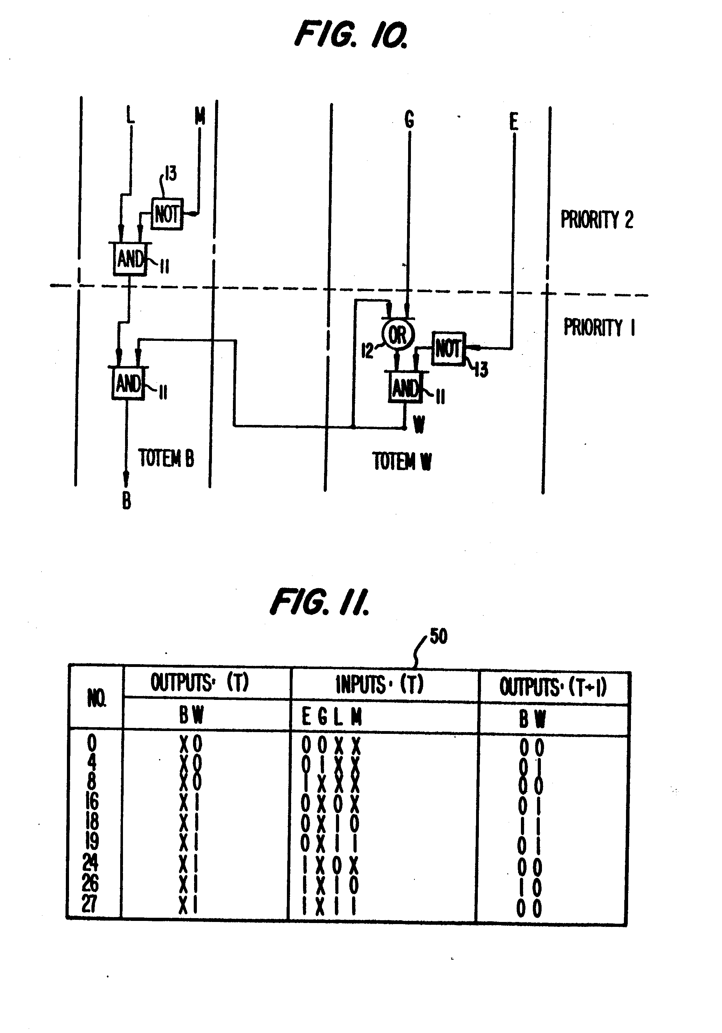

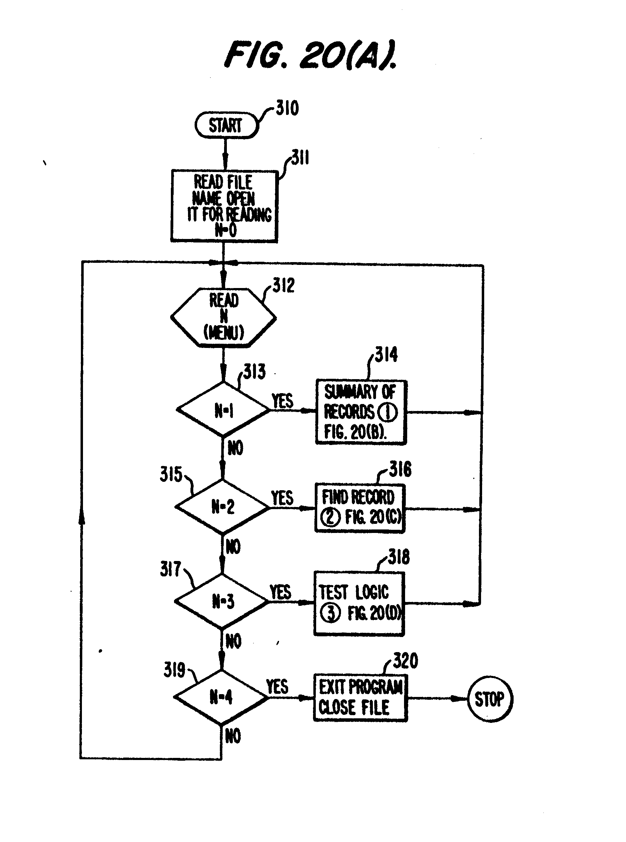

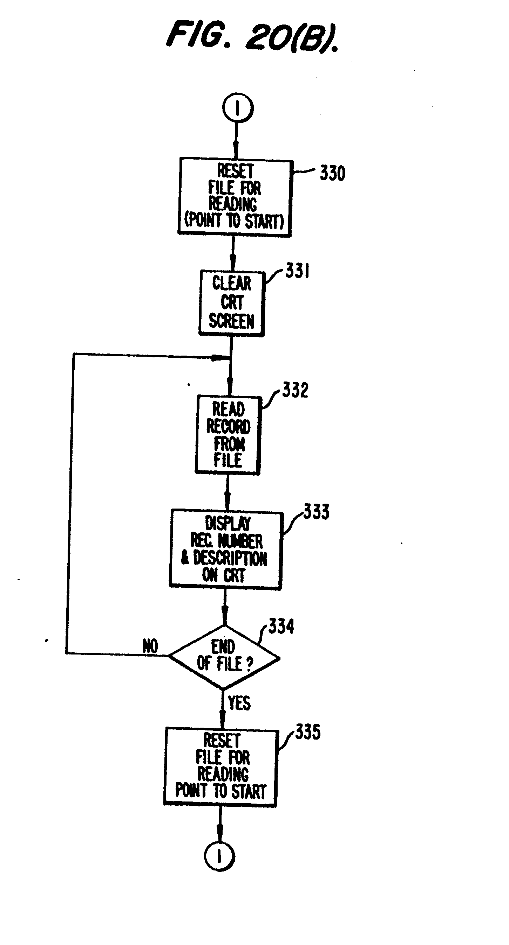

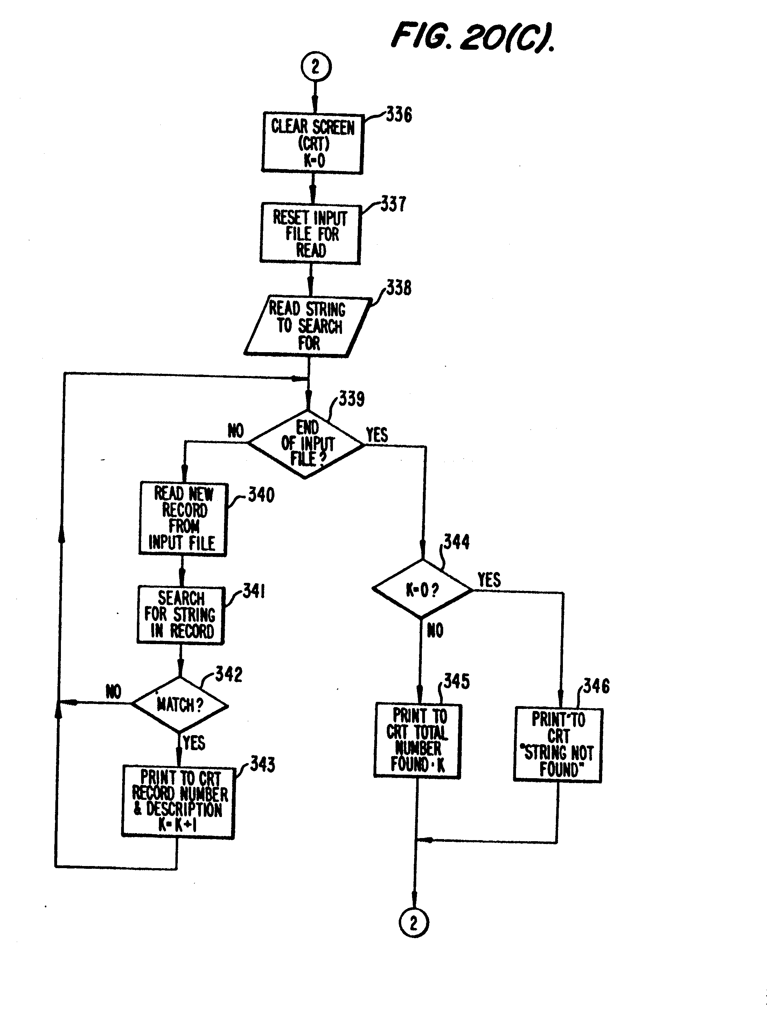

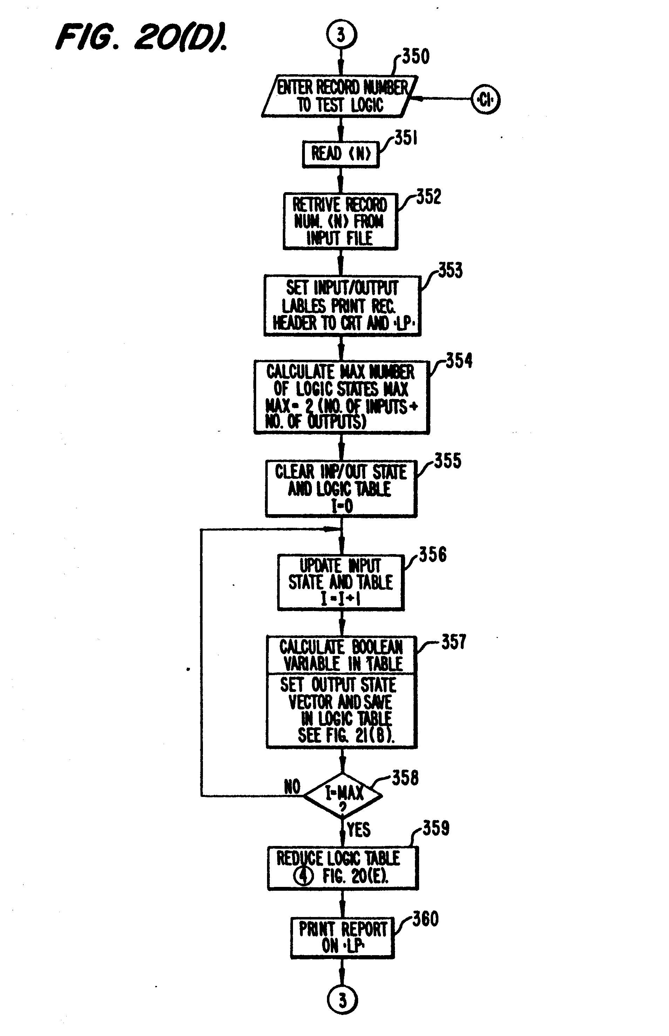

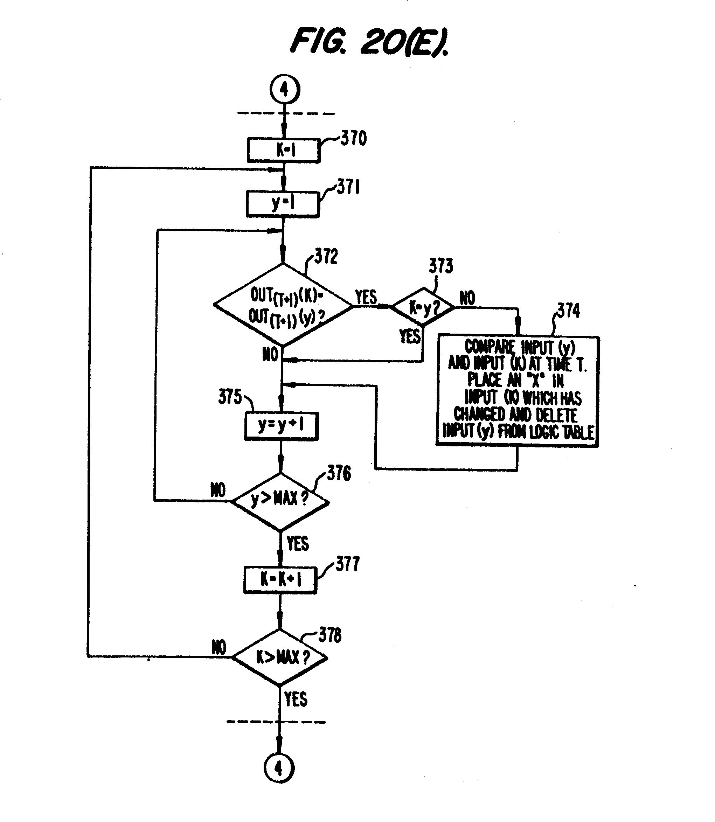

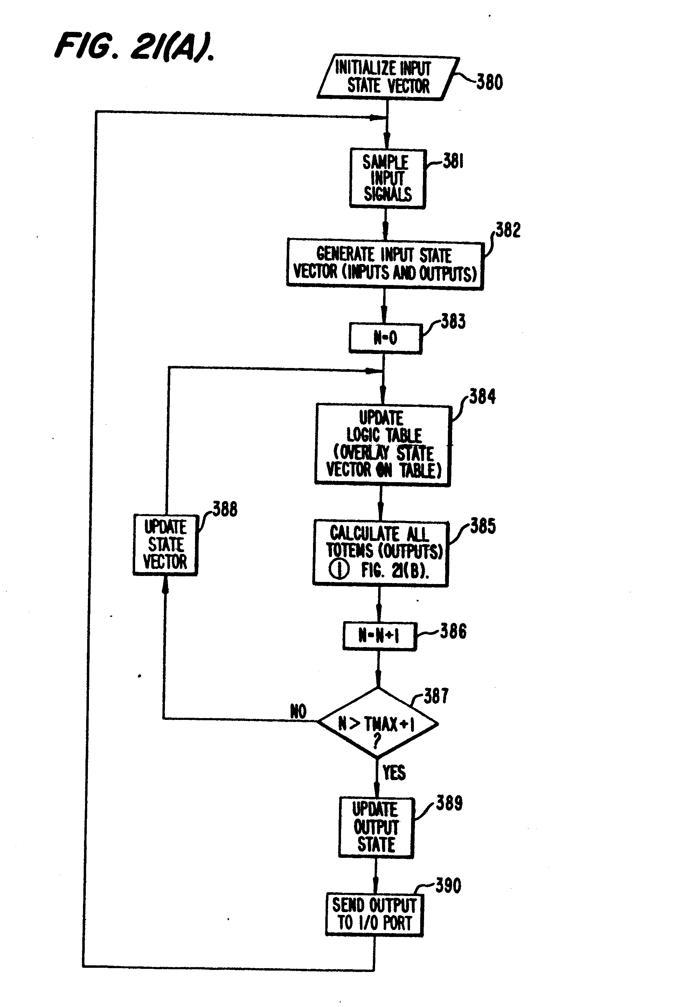

Once the logic data base is created it can be used to generate a logic diagram 30 (see Fig. 10) using the program illustrated in Fig. 20. As described earlier, there is a direct correspondence between a logic table and a logic diagram. During logic diagram generation first totems are generated and interconnections between the totems are made and any other information and labels for input and output signals are added. The logic diagram 30 for the bypass valve is illustrated in Fig. 10. To print such a diagram, a dot matrix printer or graphics capability printer should be used. Once the logic diagram 30 is generated the fluid systems engineer can review the diagram to determine if it meets his requirements.

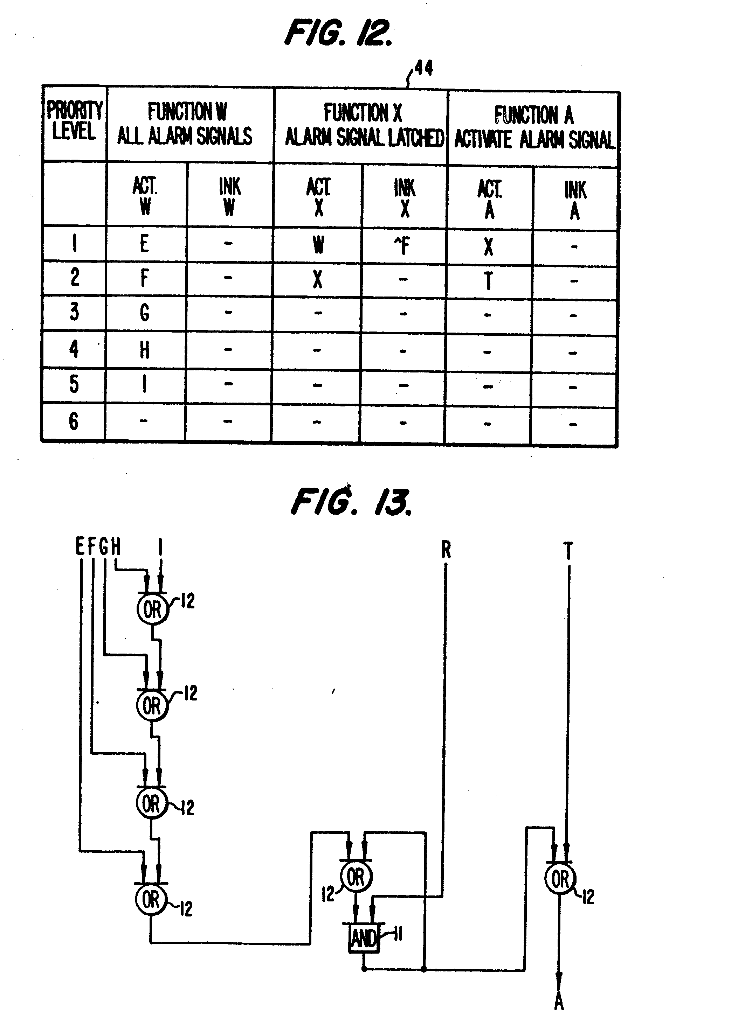

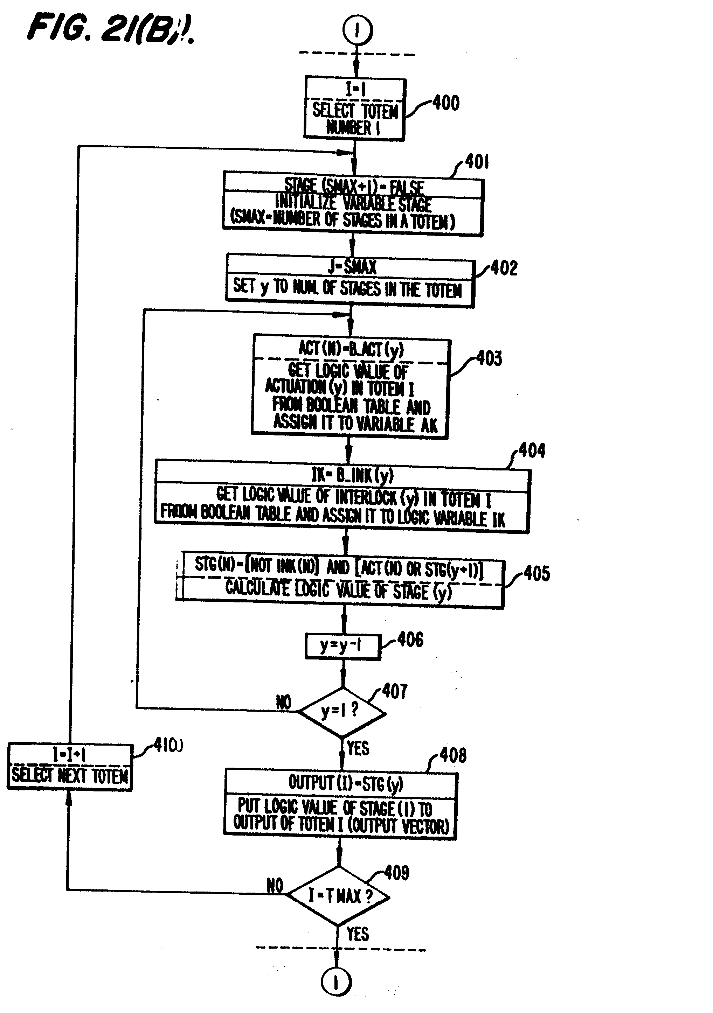

It is also possible for the fluid engineer to receive a logic state analysis 40 which is performed by the program illustrated in Fig. 21. The logic data base generated with the editor is used as an input for this program. First, the complete logic state table is generated. For each possible state and combination of inputs at Time T, the output at Time T + 1 is calculated using the Boolean equation (1). For example, as illustrated in Fig. 11 when the inputs EGLM and outputs BM are 0000 00 respectively at time T, at time T + 1 the output 00 is provided. When the inputs are 0100 and outputs are 00 at time T the outputs are 01 at time T + 1. The inputs and outputs at time T are provided for each possible state by binary counting, the inputs are then overlayed on the table and the Boolean logic equation (1) is executed for each stage (priority 1 level) to produce the relevant outputs.

The program then automatically reduces the state table and identifies logic states at a time T which have not changed with the change of input. The logic table is reduced by eliminating all but the first state which produces the same output after the output is provided. For example, in the valve example of Figs. 9-11, the state at time T with decimal value 0 and binary value 00 0000 produces outputs of 00 at time T + 1 while the state with decimal value 1 and binary value 00 0001 also produces an output of 00. The table is reduced by saving and printing the state analysis for decimal value 0. As can be seen from Fig. 11, the states with decimal values 0-3 produce the same output as do the states with decimal values 8-15, etc. The generated table logic analysis 40 is then analyzed and stable states and transient states are reported. The state in which the logic stays after completion of a sequence of operations is called a stable state. Any state through which the logic passes temporarily during a sequence of computations is called an unstable state. For example, decimal state 4 of Fig. 11 is a transient or unstable state since if the inputs remain constant and the outputs change to 01 the state would become state decimal state 18 which would produce outputs 11. Therefore, a transition from one stable state to another stable state occurs only in response to a change in the input variables. In Fig. 11 an X indicates a "don't care" signal.

Once the state analysis is performed and the system is reviewed by the fluid systems engineer the logic table can be loaded into a microcomputer which executes the general purpose execution logic illustrated in Fig. 22. The details of such an execution will be discussed later.

As an example of the flexibility and power of the present system to design and execute various logic systems the following example which applies to a simple residential alarm will be discussed. The written description given to the instrumentation and control engineer will be substantially as follows:

The residence is on apartment type having a single door and two floors. On each floor are two windows. The alarm bell should ring when the front door or any window is open. A test pushbutton allows the alarm bell to be rung and stops when the button is released. An alarm arming switch next to the front door allows an entrant to turn on the alarm after he is inside and turn off the alarm after the bell rings.

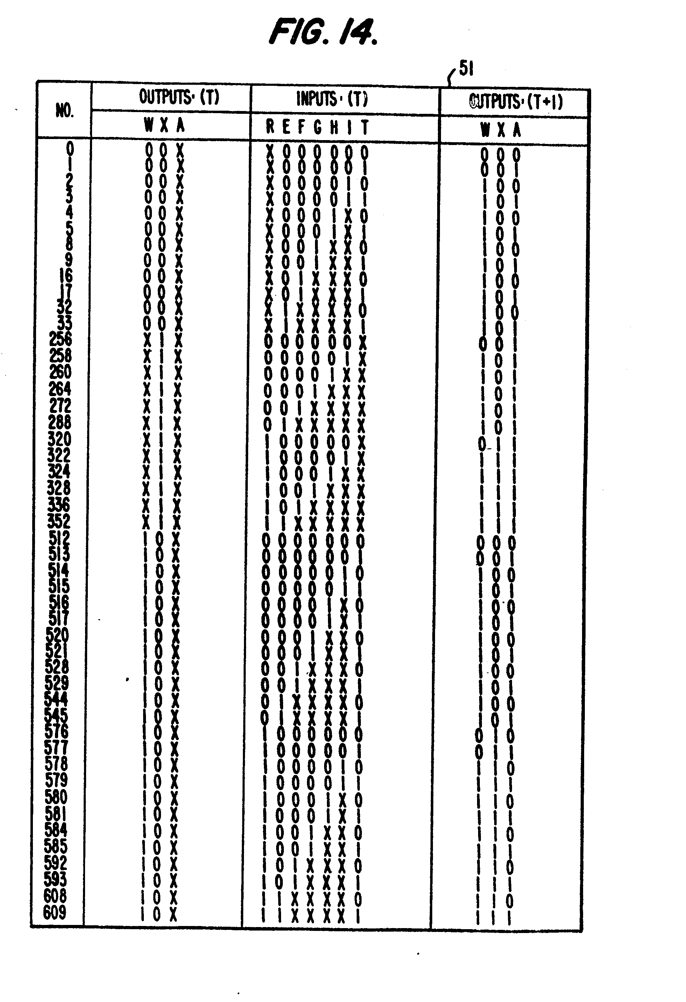

The input and output signals are defined as follows: V = front door limit switch, F = first floor window #1, G = first floor window #2, H = second floor window #1, I = second floor window #2, R = alarm arming switch, T = test pushbutton and A = activate alarm signal (ring the bell). The logic table 20 generated by the instrumentation and control engineer using the editor program of Fig. 19 is illustrated in Fig. 12 with the symbols listed above indicating the corresponding signals. Once the logic table 30 is generated, a logic diagram, as illustrated in Fig. 13, is produced using the program illustrated by Fig. 20. As can be seen by Fig. 13, when the alarm arming switch is activated any input from one of the doors or windows actuates the alarm signal A and rings the bell. After the logic diagram of Fig. 13 is generated the logic state analysis 40 of Fig. 14 can be generated and reviewed by the design engineer. When the review is completed, the table can be incorporated into a microprocessor and executed or processed by the routine of Fig. 21.

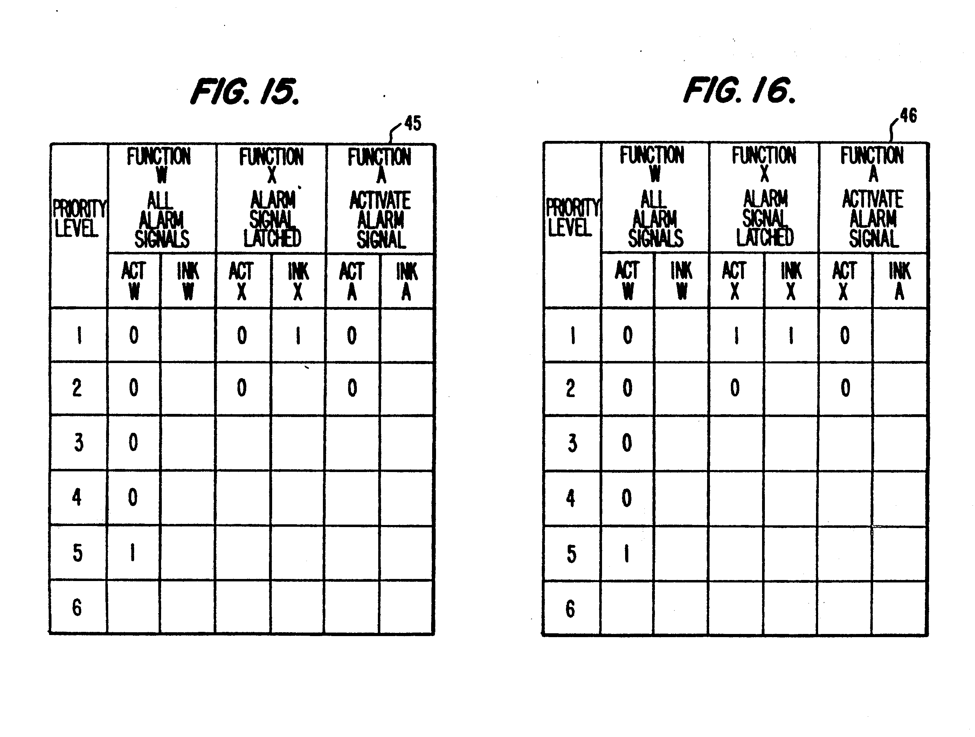

The processing of the state table of Fig. 12 using actual inputs to produce actual outputs by a microprocessor begins by sampling the input signal E-I, R and T. For example, assuming the input signals are 000110 indicating that the second floor window #2 (I) is open and that the alarm system is activated (R), this input results in an alarm being produced and assumes that in the prior state no alarm is produced (I=0) and the system is armed (R=1). The following sequence of events occurs in the microprocessor: first, the input signals are sampled and overlayed in a table representation in the memory of the microprocessor to produce a table similar to Fig. 15. Next the Boólean equation (1) is applied to each stage (priority level) of function W from lowest priority level (5) to highest priority level. For example, when the equation (1) is applied to stage 5 a 1 is produced as STG(5). When the equation (1) is applied to stage 4 a 1 is produced as STG(4). Eventually, function W assumes a value of 1 as the STG(1) output. Next the Boolean equation (1) is applied to function X and A in the same manner resulting in a zero output for function X and function A.

The table is then updated with the output values and appears as in Fig. 16. The application of the Boolean equation (1) to the table is again performed resulting in function W=1, function X=1 and function A=0.

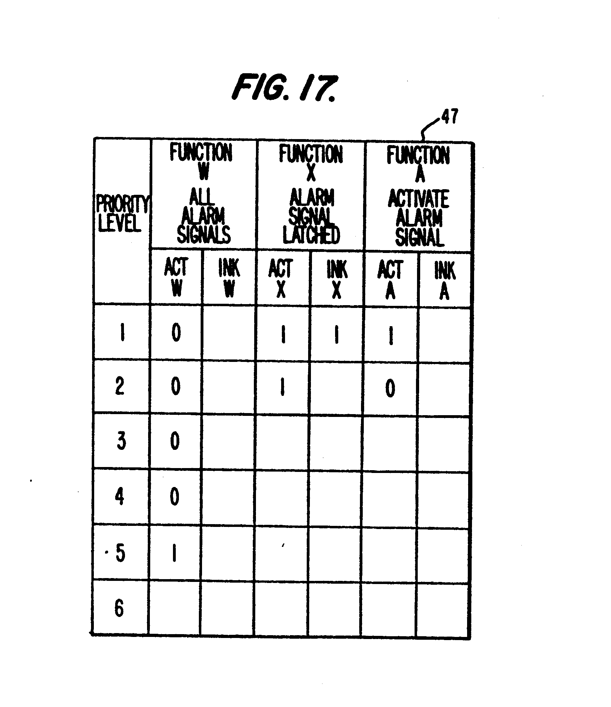

The table is again updated with the output values and appears as in Fig. 17. When the Boolean equation (1) is applied to the table the output of function W=1, function X=1 and function A=1 resulting in the ringing of the bell.

As can be seen from the above discussion, the Boolean equation must be executed a number of times equal to the number of totems multiplied by the number of priority levels in each totem. Any known nuclear power safety function can be performed using six totems and six priority levels.

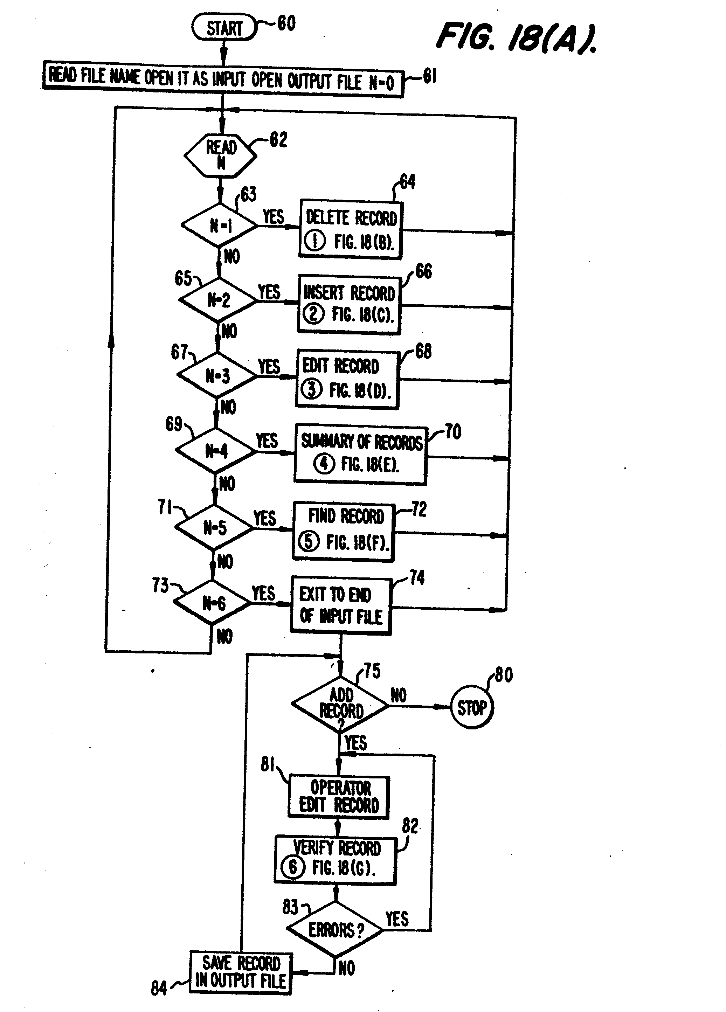

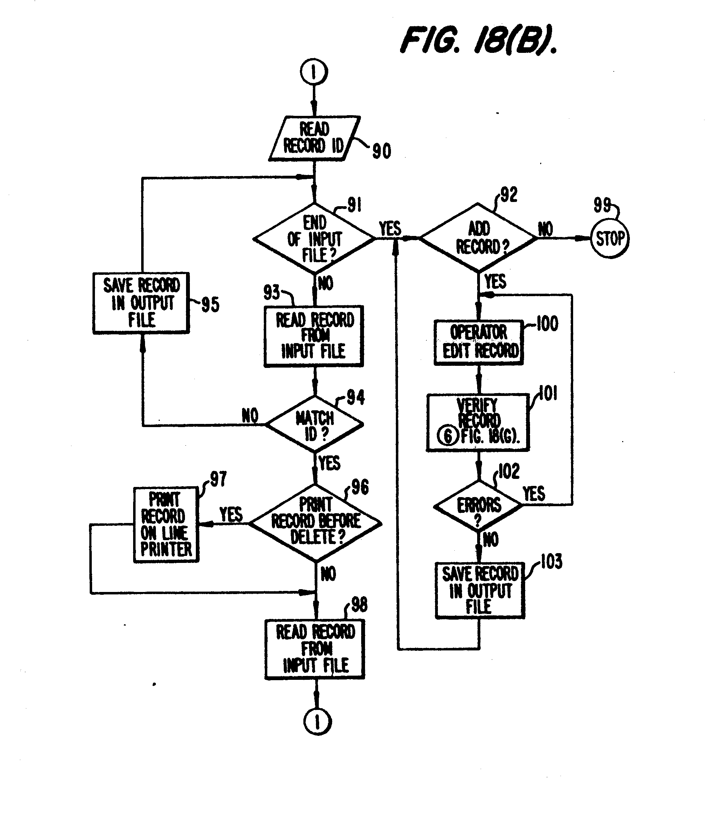

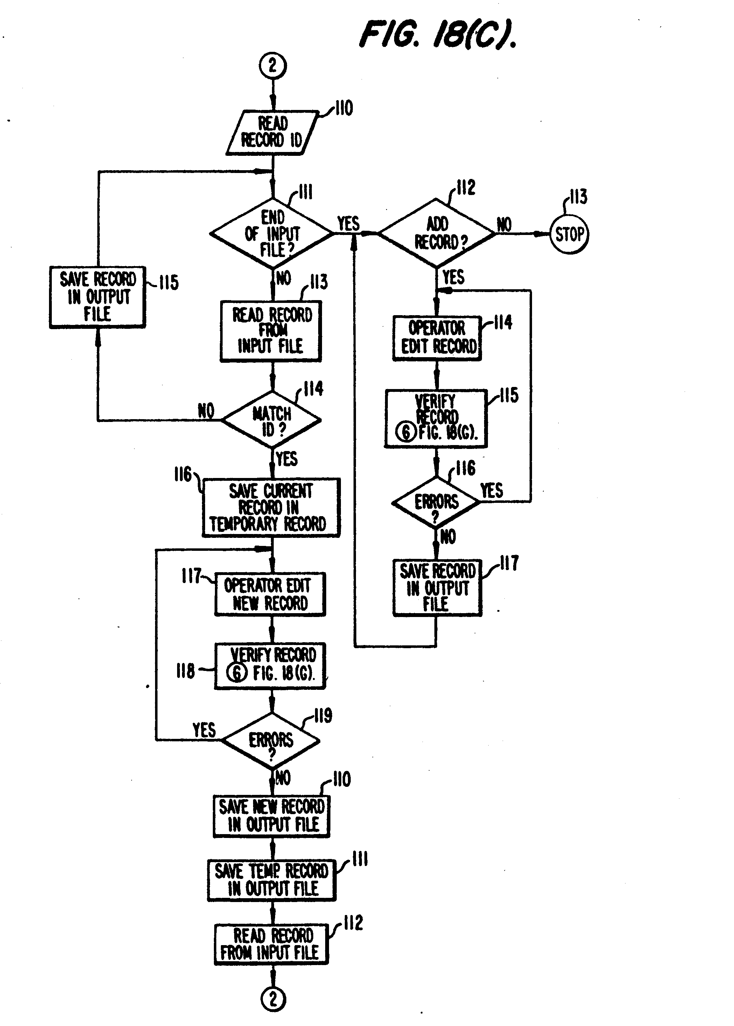

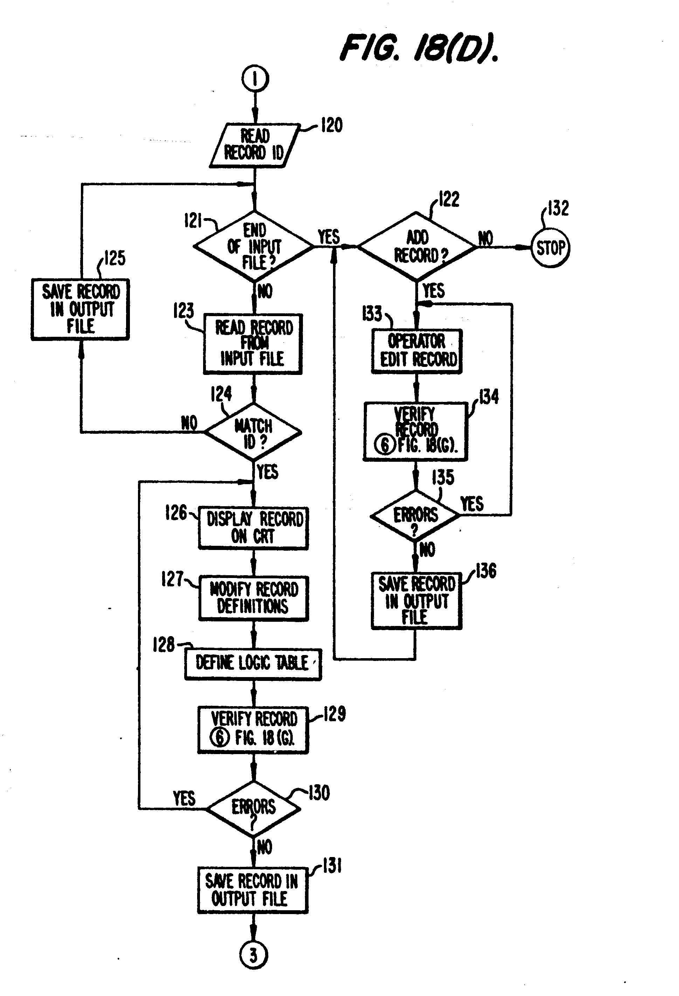

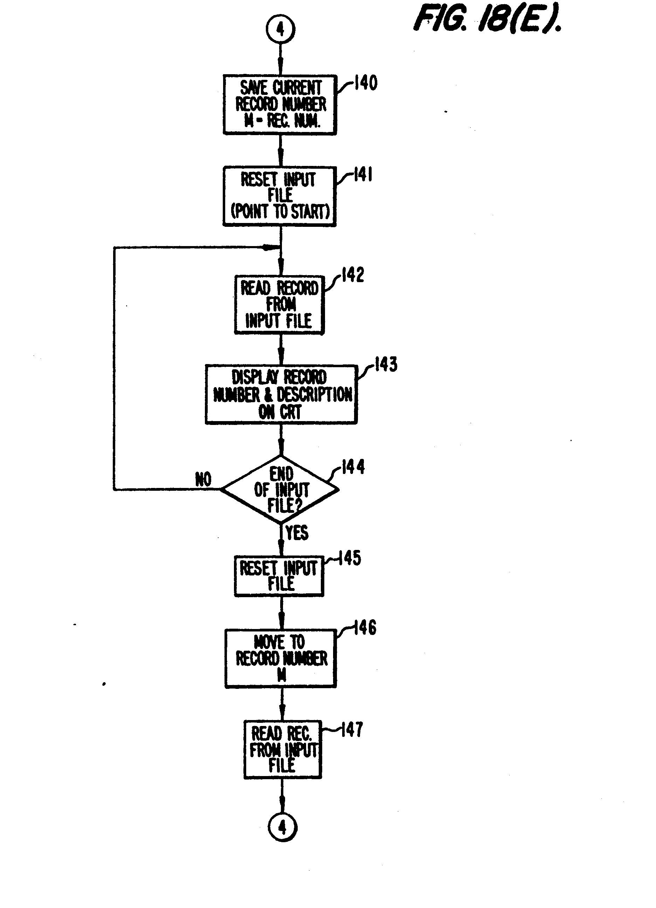

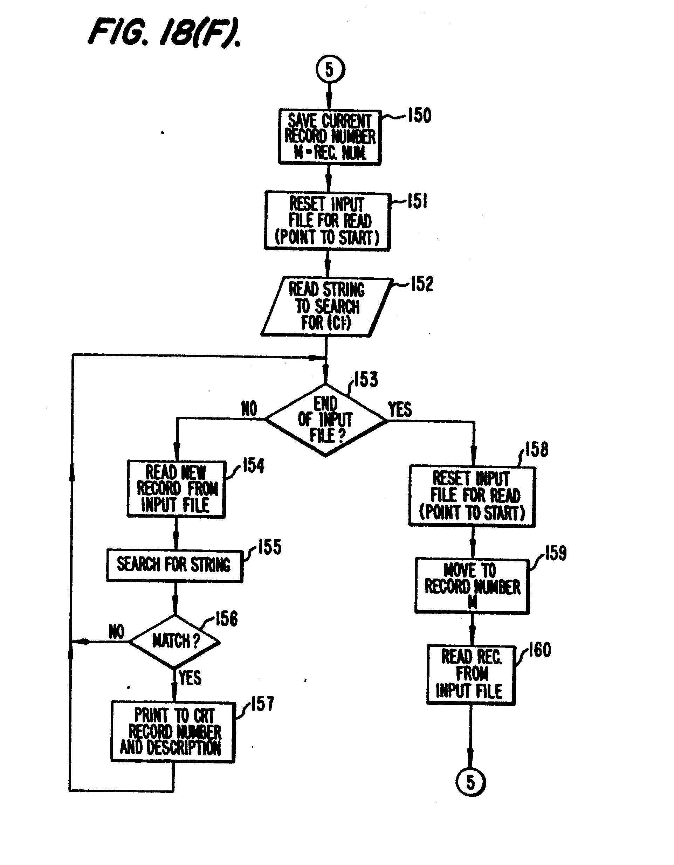

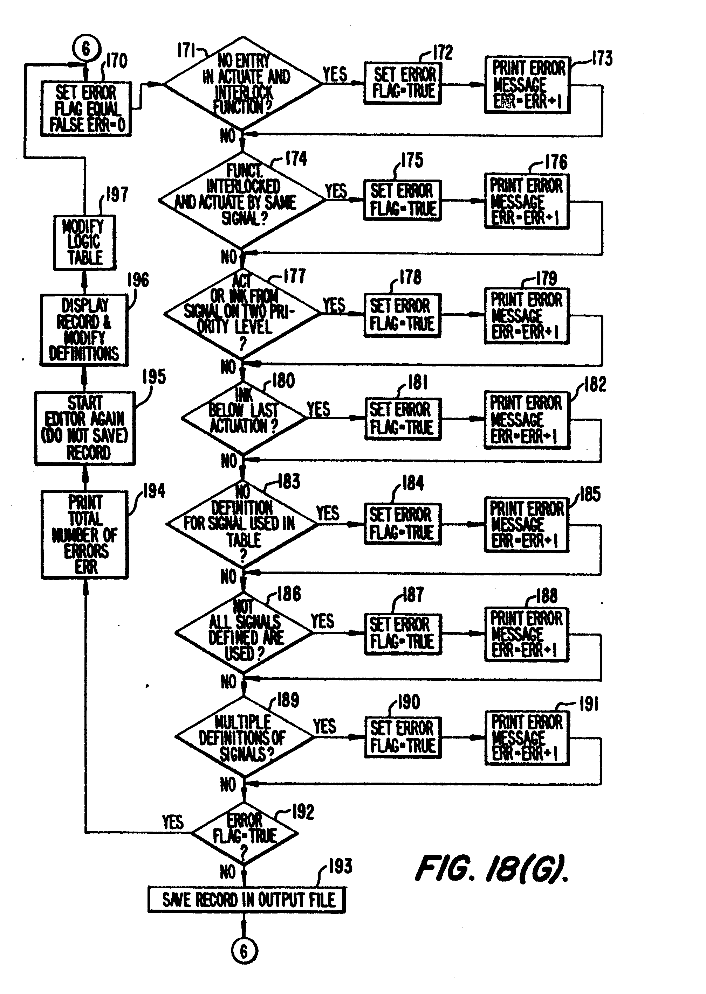

When the instrumentation and control engineer is ready to create the logic table he executes the editor routine depicted in flowchart form in Fig. 18. The editor routine is an interactive routine which allows the operator to edit records, insert records, delete records, find records and verify record commands. The program can provide a directory of all the records in the file, cross reference them, and generate a printed copy of any desired record. The information as used and edited by the operator is displayed on a computer monitor. The editor should be executed on a computer such as an Intel 86/330 having at least 80K of memory with 32K of working storage and should be implemented in Intel's version of the Pascal programming language (Pascal 86).

In Fig. 18, Fig. 18(A) acts as a supervisor and determines which of the subroutines should be executed. Fig. 18(B) is the delete record routine which deletes a record by not writing an ID matched record to the output files. Fig. 18(C) is the insert record routine which inserts records between read records as an output file is being created. Fig. 18(D) is the edit removal routine which displays the record on a display device and allows the record to be modified before it is written to the output file. Fig. 18(E) is the summary record routine which simply outputs the records to a display device. Fig. 18(F) is the find record routine and it simply searches for a matching record string and displays same when found. The verified record routine of Fig. 15(G) implements the table creation rules mentioned previously.

After the editor routine is finished creating the logic table, the program which prints out the table 20 and the logic diagram 30 is executed as illustrated in Fig. 19. The program of Fig. 19 allows the operator to print a summary of the records in a data base, find a particular record and draw the logic diagram. The Fig. 19(A) routine acts as the supervisor and jumps to the appropriate subroutine. The Fig. 19(B) routine simply displays the records in the data base. The Fig. 19(C) routine allows the operator to find a record and is very similar to Fig. 18(F). Fig. 19(D) is the supervisor routine for the draw logic diagram routine and calls the draw totem routine (Fig. 19(E)) and the connect totem routine (Fig. 19(F)). The draw totem routine of Fig. 19(E) draws the totems by checking the logic table to determine what elements are used and then places a standard symbol at the appropriate level in the matrix representation of the drawing within the appropriate totem. The connect totems routine of Fig. 19(F) also checks the logic table to determine if inputs and outputs are interconnected and then connects them with a line using a predetermined line path available in the matrix representation of the drawing.

The logic analyzer (Fig. 20) is executed next to produce the logic state analysis 40. The logic analyzer also allows a summary of records to be produced (Fig. 20(B)), a record to be found (Fig. 20(C)) and the test logic to be executed. In Fig. 20(D) the Boolean logic for the variables in the table is calculated. This Boolean calculation is the same Boolean calculation used in the general purpose table execution routine illustrated in Fig. 21(B). The reduce table routine is illustrated in Fig. 20(E) and compares the outputs of time T and T + 1 and deletes the input whenever the outputs match and the inputs, and places X (don't care) in the input.

Fig. 21 illustrates the general purpose state table execution logic which is executed by a microcomputer such as an Intel SBC 88/40 or SBC/86/30 88/45. At the beginning of the routine the input signals are sampled and the input state vector is generated.

The state vector takes the form:

$$\left[ \begin{array}{l} \text{Input}_1(T) \\ \text{Input}_2(T) \\ \quad \cdot \\ \quad \cdot \\ \quad \cdot \\ \text{Input}_m(T) \\ \text{Output}_1(T) \\ \text{Output}_2(T) \\ \quad \cdot \\ \quad \cdot \\ \quad \cdot \\ \text{Output}_k(T) \end{array} \right]$$

Inputs at Time T

Outputs at Time T

The state table is overlaid on the vector table as discussed with respect to Fig. 15 and all the totem outputs are calculated (Fig. 21(B)) as discussed with respect to Figs. 15-17. The Boolean equations which is calculated (Fig. 21(B)) for a number of times equal to T max plus 1, where T (Fig. 21(A)) max is the number of totems in the system, times S max (Fig. 21(B)), which is the number of stages or priority levels in the totem. The calculation of the Boolean equation this number of times ensures that any auxiliary logic signal created in one totem will propagate through all totems even if all totems are serially linked in a chain. Once the outputs are all calculated, the output state is updated and the outputs sent to the output port. The Boolean logic equation for the basic logic element appears in the routine of Fig. 21(B). Once the outputs are produced the code is executed again beginning with a sample of the inputs.

The many features and advantages of the invention are apparent from the detailed specification and thus it is intended by the appended claims to cover all such features and advantages of the method which fall within the true spirit and scope of the invention. Further, since numerous modifications and changes will readily occur to those skilled in the art, it is not desired to limit the invention to the exact operation illustrated and described. Accordingly, all suitable modifications and improvements may be resorted to, falling within the scope of the invention. For example, it is possible to link the routines of Figs. 18-20 into a single routine.

## IDENTIFICATION OF REFERENCE NUMERALS USED IN THE DRAWINGS

| LEGEND | REF. NO. | FIGURE |
|---|---|---|
| AND | 11 | 3 |
| AND | 11 | 5 |
| AND | 11 | 7(A) |
| AND | 11 | 7(B) |
| AND | 11 | 10 |
| AND | 11 | 13 |
| OR | 12 | 3 |
| OR | 12 | 5 |
| OR | 12 | 7(A) |
| OR | 12 | 7(B) |
| OR | 12 | 13 |
| NOT | 13 | 3 |
| NOT | 13 | 5 |
| NOT | 13 | 5 |
| NOT | 13 | 7(A) |
| NOT | 13 | 7(B) |
| NOT | 13 | 10 |
| VERBAL LOGIC REQUIREMENTS | 20 | 1 |
| VERBAL LOGIC REQUIREMENTS | 20 | 2 |
| INTERLOCK SKETCHES | 21 | 1 |
| SYSTEMS DESIGN | 22 | 1 |
| SYSTEMS DESIGN | 22 | 2 |
| LOGIC DIAGRAMS | 23 | 1 |
| ELEMENTARY WIRING DIAGRAMS | 24 | 1 |
| ELEMENTARY WIRING DIAGRAMS | 24 | 2 |
| INTERCONNECT DRAWINGS | 25 | 1 |
| INTERCONNECT DRAWINGS | 25 | 2 |
| SCHEMATIC DRAWINGS | 26 | 1 |
| WIRING LISTS | 27 | 1 |
| HARDWARE DESIGN | 28 | 1 |
| LOGIC CARD SET-UP | 29 | 1 |
| LOGIC DATA BASE | 30 | 2 |
| INTERLOCK LOGIC DIAGRAMS | 31 | 2 |
| LOGIC STATE ANALYSIS | 32 | 2 |

## IDENTIFICATION OF REFERENCE NUMERALS USED IN THE DRAWINGS

| LEGEND | REF. NO. | FIGURE |
|---|---|---|
| APPLICATION SOFTWARE | 33 | 2 |
| HARDWARE DESIGN | 34 | 2 |
| HARDWARE & SOFTWARE INTEGRATION | 35 | 2 |
| FUNCTION BLE | 40 | 4 |
| FUNCTION A | 41 | 6 |
| FUNCTION STG (1) | 42 | 8 |
| START | 60 | 18(A) |
| READ FILE NAME OPEN IT AS INPUT | | |
| OPEN OUTPUT FILE N=0 | 61 | 18(A) |
| READ N | 62 | 18(A) |
| N=1 | 63 | 18(A) |
| DELETE RECORD (1) FIG. 18(B) | 64 | 18(A) |
| N=2 | 65 | 18(A) |
| N=2 | 65 | 18(A) |
| INSERT RECORD (2) FIG. 18(C) | 66 | 18(A) |
| N=3 | 67 | 18(A) |
| EDIT RECORD (3) FIG. 18(D) | 68 | 18(A) |
| N=4 | 69 | 18(A) |
| SUMMARY OF RECORDS (4) FIG. 18(E) | 70 | 18(A) |
| N=5 | 71 | 18(A) |
| FIND RECORD (5) FIG. 18(F) | 72 | 18(A) |
| N=6 | 73 | 18(A) |
| EXIT TO END OF INPUT FILE | 74 | 18(A) |
| ADD RECORD | 75 | 18(A) |
| STOP | 80 | 18(A) |
| OPERATOR EDIT RECORD | 81 | 18(A) |
| VERIFY RECORD (6) FIG. 18(G) | 82 | 18(A) |
| ERRORS | 83 | 81(A) |
| SAVE RECORD IN OUTPUT FILE | 84 | 18(A) |
| READ RECORD ID | 90 | 18(B) |
| END OF INPUT FILE | 91 | 18(B) |
| ADD RECORD | 92 | 18(B) |
| READ RECORD FROM INPUT FILE | 93 | 18(B) |
| MATCH ID | 94 | 18(B) |

0209795
52,504

## IDENTIFICATION OF REFERENCE NUMERALS USED IN THE DRAWINGS

| LEGEND | REF. NO. | FIGURE |
|---|---|---|
| SAVE RECORD IN OUTPUT FILE | 95 | 18(B) |
| PRINT RECORD BEFORE DELETE | 96 | 18(B) |
| PRINT RECORD ON LINE PRINTER | 97 | 18(B) |
| READ RECORD FROM INPUT FILE | 98 | 18(B) |
| STOP | 99 | 18(B) |
| OPERATOR EDIT RECORD | 100 | 18(B) |
| VERIFY RECORD (6) FIG. 18(G) | 101 | 18(B) |
| ERRORS | 102 | 18(B) |
| SAVE RECORD IN OUTPUT FILE | 103 | 18(B) |
| READ RECORD ID | 110 | 18(C) |
| SAVE NEW RECORD IN OUTPUT FILE | 110 | 18(C) |
| END OF INPUT FILE | 111 | 18(C) |
| SAVE TEMP. RECORD IN OUTPUT FILE | 111 | 18(C) |
| ADD RECORD | 112 | 18(C) |
| READ RECORD FROM INPUT FILE | 112 | 18(C) |
| STOP | 113 | 18(C) |
| READ RECORD FROM INPUT FILE | 113 | 18(C) |
| OPERATOR EDIT RECORD | 114 | 18(C) |
| MATCH ID | 114 | 18(C) |
| SAVE RECORD IN OUTPUT FILE | 115 | 18(C) |
| VERIFY RECORD (6) FIG. 18(G) | 115 | 18(C) |
| SAVE CURRENT RECORD IN TEMPORARY RECORD | 116 | 18(C) |
| ERRORS | 116 | 18(C) |
| OPERATOR EDIT NEW RECORD | 117 | 18(C) |
| SAVE RECORD IN OUTPUT FILE | 117 | 18(C) |
| VERIFY RECORD (6) FIG. 18(G) | 118 | 18(C) |
| ERRORS | 119 | 18(C) |
| READ RECORD ID | 120 | 18(D) |
| END OF INPUT FILE | 121 | 18(D) |
| ADD RECORD | 122 | 18(D) |
| READ RECORD FROM INPUT FILE | 123 | 18(D) |
| MATCH ID | 124 | 18(D) |
| SAVE RECORD IN OUTPUT FILE | 125 | 18(D) |

IDENTIFICATION OF REFERENCE NUMERALS USED IN THE DRAWINGS

| LEGEND | REF. NO. | FIGURE |
|---|---|---|
| DISPLAY RECORD ON CRT | 126 | 18(D) |
| MODIFY RECORD DEFINITIONS | 127 | 18(D) |
| DEFINE LOGIC TABLE | 128 | 18(D) |
| VERIFY RECORD (6) FIG. 18(G) | 129 | 18(D) |
| ERRORS | 130 | 18(D) |
| SAVE RECORD IN OUTPUT FILE | 131 | 18(D) |
| STOP | 132 | 18(D) |
| OPERATOR EDIT RECORD | 133 | 18(D) |
| VERIFY RECORD (6) Fig. 18(G) | 134 | 18(D) |
| ERRORS | 135 | 18(D) |
| SAVE RECORD IN OUTPUT FILE | 136 | 18(D) |
| SAVE CURRENT RECORD NUMBER M - REC. NUM. | 140 | 18(E) |
| RESET INPUT FILE (POINT TO START) | 141 | 18(E) |
| READ RECORD FROM INPUT FILE | 142 | 18(E) |
| DISPLAY RECORD NUMBER & DESCRIPTION ON CRT | 143 | 18(E) |
| END OF INPUT FILE | 144 | 18(E) |
| RESET INPUT FILE | 145 | 18(E) |
| MOVE TO RECORD NUMBER M | 146 | 18(E) |
| READ REC. FROM INPUT FILE | 147 | 18(E) |
| SAVE CURRENT RECORD NUMBER M - REC. NUM. | 150 | 18(F) |
| RESET INPUT FILE FOR READ (POINT TO START) | 151 | 18(F) |
| READ STRING TO SEARCH FOR (:C1:) | 152 | 18(F) |
| END OF INPUT FILE | 153 | 18(F) |
| READ NEW RECORD FROM INPUT FILE | 154 | 18(F) |
| SEARCH FOR STRING | 155 | 18(F) |
| MATCH | 156 | 18(F) |
| PRINT TO CRT RECORD NUMBER AND DESCRIPTION | 157 | 18(F) |
| RESET INPUT FILE FOR READ (POINT TO START) | 158 | 18(F) |

## IDENTIFICATION OF REFERENCE NUMERALS USED IN THE DRAWINGS

| LEGEND | REF. NO. | FIGURE |
|---|---|---|
| MOVE TO RECORD NUMBER | 159 | 18(F) |
| READ REC. FROM INPUT FILE | 160 | 18(F) |
| SET ERROR FLAG EQUAL FALSE ERR=0 | 170 | 18(G) |
| NO ENTRY IN ACTUATE AND | | |
| INTERLOCK FUNCTION | 171 | 18(G) |
| SET ERROR FLAG - TRUE | 172 | 18(G) |
| PRINT ERROR MESSAGE ERR - ERR + 1 | 173 | 18(G) |
| FUNCT. INTERLOCIED AND | | |
| ACTUATE BY SAME SIGNAL | 174 | 18(G) |
| SET ERROR FLAG - TRUE | 175 | 18(G) |
| PRINT ERROR MESSAGE ERR - ERR + 1 | 176 | 18(G) |
| ACT OR INK FROM SIGNAL ON | | |
| TWO PRIORITY LEVEL | 177 | 18(G) |
| SET ERROR FLAG - TRUE | 178 | 18(G) |
| PRINT ERROR MESSAGE ERR - ERR + 1 | 179 | 18(G) |
| INK BELOW LAST ACTUATION | 180 | 18(G) |
| SET ERROR FLAG - TRUE | 181 | 18(G) |
| PRINT ERROR MESSAGE ERR - ERR + 1 | 182 | 18(G) |
| NO DEFINITION FOR SIGNAL USED | | |
| IN TABLE | 183 | 18(G) |
| SET ERROR FLAG - TRUE | 184 | 18(G) |
| PRINT ERROR MESSAGE ERR - ERR + 1 | 185 | 18(G) |
| NOT ALL SIGNALS DEFINED ARE USED | 186 | 18(G) |
| SET ERROR FLAG - TRUE | 187 | 18(G) |
| PRINT ERROR MESSAGE ERR - ERR + 1 | 188 | 81(G) |
| MULTIPLE DEFINITIONS OF SIGNALS | 189 | 18(G) |
| SET ERROR FLAG - TRUE | 190 | 18(G) |
| PRINT ERROR MESSAGE ERR - ERR + 1 | 191 | 18(G) |
| ERROR FLAG - TRUE | 192 | 18(G) |
| SAVE RECORD IN OUTPUT FILE | 193 | 18(G) |
| PRINT TOTAL NUMBER OF ERRORS ERR | 194 | 18(G) |
| START EDITOR AGAIN | | |
| (DO NOT SAVE RECORD) | 195 | 18(G) |

## IDENTIFICATION OF REFERENCE NUMERALS USED IN THE DRAWINGS

| LEGEND | REF. NO. | FIGURE |
|---|---|---|
| DISPLAY RECORD & MODIFY | | |
| DEFINITIONS | 196 | 18(G) |
| MODIFY LOGIC TABLE | 197 | 18(G) |
| START | 200 | 19(A) |
| READ FILE NAME OPEN IT FOR | | |
| READING N=0 | 201 | 19(A) |
| READ IN (MENU) | 202 | 19(A) |
| N=1 | 203 | 19(A) |
| SUMMARY OF RECORDS (1) FIG. 19(B) | 204 | 19(A) |
| N=2 | 205 | 19(A) |
| FIND RECORD (2) FIG. 19(C) | 206 | 19(A) |
| N=3 | 207 | 19(A) |
| DRAW LOGIC DIAGRAM (3) FIG. 19(D) | 208 | 19(A) |
| N=4 | 209 | 19(A) |
| EXIT PROGRAM CLOSE FILE | 210 | 19(A) |
| RESET FILE FOR READING | | |
| (POINT TO START) | 220 | 19(B) |
| CLEAR CRT SCREEN | 221 | 19(B) |
| READ RECORD FROM FILE | 222 | 19(B) |
| DISPLAY REC. NUMBER & | | |
| DESCRIPTION ON CRT | 223 | 19(B) |
| END OF FILE | 224 | 19(B) |
| RESET FILE FOR READING | | |
| POINT TO START | 225 | 19(B) |
| CLEAR SCREEN (CRT) K=0 | 230 | 19(C) |
| RESET INPUT FILE FOR READ | 231 | 19(C) |
| READ STRING TO SEARCH FOR | 232 | 19(C) |
| END OF INPUT FILE | 233 | 19(C) |
| READ NEW RECORD FROM INPUT FILE | 234 | 19(C) |
| SEARCH FOR STRING IN RECORD | 235 | 19(C) |
| MATCH | 236 | 19(C) |
| PRINT TO CRT RECORD NUMBER * | | |
| DESCRIPTION K = K + 1 | 237 | 19(C) |
| K=0 | 238 | 19(C) |

## IDENTIFICATION OF REFERENCE NUMERALS USED IN THE DRAWINGS

| LEGEND | REF. NO. | FIGURE |
|---|---|---|
| PRINT TO CRT TOTAL NUMBER FOUND K | 239 | 19(C) |
| PRINT TO CRT "STRING NOT FOUND" | 240 | 19(C) |
| ENTER RECORD NUMBER TO DRAW LOGIC $>$ N | 250 | 19(D) |
| RETRIEVE RECORD NUMBER N FROM INPUT FILE | 251 | 19(D) |
| SCAN RECORD | 252 | 19(D) |
| MORE THAN TWO TOTEMS | 253 | 19(D) |
| SET :LP: TO 80 CHARACT./LINE SET SCALE = 1 | 254 | 19(D) |
| SET :LP: TO 132 CHARACT./LINE SET SCALE = 1/2 | 255 | 19(D) |
| PRINT HEADER TOP LABLE TO :LP: | 256 | 19(D) |
| DRAW TOTEMS SAVE IN GRAPH (4) FIG. 19(E) | 257 | 19(D) |
| CONNECT TOTEMS SAVE IN GRAPH (5) FIG. 19(F) | 258 | 19(D) |
| PRINT GRAPH TO :LP: | 259 | 19(D) |
| PRINT ON :LP: BOTTOM LABLE & SIGNAL DEFINITIONS | 260 | 19(D) |
| RESET PRINTER & INPUT FILE | 261 | 19(D) |
| T=1 | 271 | 19(E) |
| y = NSTG | 272 | 19(E) |
| K = 0 | 273 | 19(E) |
| ACTT (y,2) $\neq$ "_" | 274 | 19(E) |
| K = K + 1 | 275 | 19(E) |
| ACTT (y,1) = "$\wedge$" | 276 | 19(E) |
| K = K + 2 | 277 | 19(E) |
| INKT (y,2) $\neq$ "_" | 278 | 19(E) |
| K = K + 3 | 279 | 19(E) |
| INKT (y,1) = "$\wedge$" | 280 | 19(E) |
| K = K + 4 | 281 | 19(E) |
| DRAW ELEMENT K IN TOTEM T ON LEVEL y | 282 | 19(E) |

0209795..

·52,504

## IDENTIFICATION OF REFERENCE NUMERALS USED IN THE DRAWINGS

| LEGEND | REF. NO. | FIGURE |
|---|---|---|
| $y = y - 1$ | 283 | 19(E) |
| $y = 0$ | 284 | 19(E) |
| STGT (1) = "." DRAW DELAY AT THE OUTPUT OF TOTEM T | 285 286 | 19(E) 19(E) |
| $T = T + 1$ | 287 | 19(E) |
| $T > MAX$ | 288 | 19(E) |
| $T = 1$ | 290 | 19(F) |
| $N = 1$ | 291 | 19(F) |
| $y = NSTG$ | 292 | 19(F) |
| $STG(T) = ACT_N(y)$ DRAW CONNECTION BETWEEN OUTPUT OF TOTEM T AND ACT (y) IN TOTEM N | 293 294 | 19(F) 19(F) |
| $T = N$ | 295 | 19(F) |
| $STG(T) = INK_N(y)$ DRAW CONNECTION BETWEEN OUTPUT OF TOTEM T AND INTERLOCK (y) IN TOTEM N | 296 297 | 19(F) 19(F) |
| $y = y - 1$ | 298 | 19(F) |
| $y = 0$ | 299 | 19(F) |
| $N = N + 1$ | 300 | 19(F) |
| $N > MAX$ | 301 | 19(F) |
| $T = T + 1$ | 302 | 19(F) |
| $T > MAX$ | 303 | 19(F) |
| START | 310 | 20(A) |
| READ FILE NAME OPEN IT FOR READING $N = 0$ | 311 | 20(A) |
| READ IN (MENU) | 312 | 20(A) |
| $N = 1$ | 313 | 20(A) |
| SUMMARY OF RECORDS (1) FIG. 20(B) | 314 | 20(A) |
| $N = 2$ | 315 | 20(A) |
| FIND RECORD (2) FIG. 20(C) | 316 | 20(A) |
| $N = 3$ | 317 | 20(A) |
| TEST LOGIC (3) FIG. 20(D) | 318 | 20(A) |

## IDENTIFICATION OF REFERENCE NUMERALS USED IN THE DRAWINGS

| LEGEND | REF. NO. | FIGURE |
|---|---|---|
| N = 4 | 319 | 20(A) |
| EXIT PROGRAM CLOSE FILE | 320 | 20(A) |
| RESET FILE FOR READING (POINT TO START) | 330 | 20(B) |
| CLEAR CRT SCREEN | 331 | 20(B) |
| READ RECORD FROM FILE | 332 | 20(B) |
| DISPLAY REC. NUMBER & DESCRIPTION ON CRT | 333 | 20(B) |
| END OF FILE | 334 | 20(B) |
| RESET FILE FOR READING POINT TO START | 335 | 20(B) |
| CLEAR SCREEN (CRT) K = 0 | 336 | 20(C) |
| RESET INPUT FILE FOR READ | 337 | 20(C) |
| READ STRING TO SEARCH FOR | 338 | 20(C) |
| END OF INPUT FILE | 339 | 20(C) |
| READ NEW RECORD FROM INPUT FILE | 340 | 20(C) |
| SEARCH FOR STRING IN RECORD | 341 | 20(C) |
| MATCH | 342 | 20(C) |
| PRINT TO CRT RECORD NUMBER & DESCRIPTION K = K + 1 | 343 | 20(C) |
| K = 0 | 344 | 20(C) |
| PRINT TO CRT TOTAL NUMBER FOUND K | 345 | 20(C) |
| PRINT TO CRT "STRING NOT FOUND" | 346 | 20(C) |
| ENTER RECORD NUMBER TO TEST LOGIC | 350 | 20(D) |
| READ $\langle N \rangle$ | 351 | 20(D) |
| RETRIEVE RECORD NUM. N FROM | 352 | 20(D) |
| SET INPUT/OUTPUT LABLES PRINT REC. HEADER TO CRT AND :LP: | 353 | 20(D) |
| CALCULATE MAX NUMBER OF LOGIC STATES MAX MAX = 2 (NO. OF INPUTS + NO. OF OUTPUTS) | 354 | 20(D) |
| CLEAR INP/OUT STATE AND LOGIC TABLE I = 0 | 355 | 20(D) |

Page *28*

0209795
52,504

## IDENTIFICATION OF REFERENCE NUMERALS USED IN THE DRAWINGS

| LEGEND | REF. NO. | FIGURE |
|---|---|---|
| UPDATE INPUT STATE AND TABLE I = I + 1 | 356 | 20(D) |
| CALCULATE BOOLEAN VARIABLE IN TABLE; SET OUTPUT STATE VECTOR AND SAVE IN LOGIC TABLE SEE FIG. 21(B) | 357 | 20(D) |
| I = MAX | 358 | 20(D) |
| REDUCE LOGIC TABLE (4) FIG. 20(E) | 359 | 20(D) |
| PRINT REPORT ON :LP: | 360 | 20(D) |
| K = 1 | 370 | 20(E) |
| y = 1 | 371 | 20(E) |
| $OUT_{(T+1)}(K) = OUT_{(T+1)}(y)$ | 372 | 20(E) |
| K = y | 373 | 20(E) |
| COMPARE INPUT (y) AND INPUT (K) AT TIME T. PLACE AN "X" IN INPUT (K) WHICH HAS CHANGED AND DELETE INPUT (y) FROM LOGIC TABLE | 374 | 20(E) |
| y > MAX | 376 | 20(E) |
| K = K + 1 | 377 | 20(E) |
| K > MAX | 378 | 20(E) |
| INITIALIZE INPUT STATE VECTOR | 380 | 21(A) |
| SAMPLE INPUT SIGNALS | 381 | 21(A) |
| GENERATE INPUT STATE VECTOR (INPUTS AND OUTPUTS) | 382 | 21(A) |
| N = 0 | 383 | 21(A) |
| UPDATE LOGIC TABLE (OVERLAY STATE VECTOR ON TABLE) | 384 | 21(A) |
| CALCULATE ALL TOTEMS (OUTPUTS) (1) FIG. 21(B) | 385 | 21(A) |
| N = N + 1 | 386 | 21(A) |
| N > TMAX + 1 | 387 | 21(A) |
| UPDATE STATE VECTOR | 388 | 21(A) |
| UPDATE OUTPUT STATE | 389 | 21(A) |
| SEND OUTPUT TO 1/0 PORT | 390 | 21(A) |

0209795
52,504

## IDENTIFICATION OF REFERENCE NUMERALS USED IN THE DRAWINGS

| LEGEND | REF. NO. | FIGURE |
|---|---|---|
| I = 1; SELECT TOTEM NUMBER 1 | 400 | 21(B) |
| STAGE (SMAX + 1) = FALSE; INITIALIZE VARIABLE STAGE (SMAX = NUMBER OF STAGES IN A TOTEM) | 401 | 21(B) |
| J = SMAX; SET y TO NUM. OF STAGES IN THE TOTEM | 402 | 21(B) |
| ACT (N) = B_ACT(y); GET LOGIC VALUE OF ACTUATION (y) IN TOTEM I FROM BOOLEAN TABLE AND ASSIGN IT TO VARIABLE AK | 403 | 21(B) |
| IK = B_INK(y); GET LOGIC VALUE OF INTERLOCK (y) IN TOTEM I FROM BOOLEAN TABLE AND ASSIGN IT TO LOGIC VARIABLE IK | 404 | 21(B) |
| STG (N) = [NOT INK (N)] AND [ACT (N) OR STG (y + 1)]; CALCULATE LOGIC VALUE OF STAGE (y) | 405 | 21(B) |
| y = y −1 | 406 | 21(B) |
| y = 1 | 407 | 21(B) |
| OUTPUT (I) = STG (y); PUT LOGIC VALUE OF STAGE (1) TO OUTPUT OF TOTEM I (OUTPUT VECTOR) | 408 | 21(B) |
| I = TMAX | 409 | 21(B) |
| I = I + 1; SELECT NEXT TOTEM | 410 | 21(B) |

— 1 —

CLAIMS:

1.   A method of creating and executing table driven logic for a logic system having input signals, characterized by the steps of:

(a)   entering mnemonics corresponding to signals in the system;

(b)   creating a logic table (20) from the entered mnemonics using at least AND, OR and NOT operations;

(c)   verifying the logic table for its accuracy; and

(d)   executing the logic defined by the logic table using the input signals to produce output signals.

2.   A method as recited in claim 1, wherein the logic table defines the input and output structure of a basic logic element (10).

3.   A method as recited in claim 2, wherein said basic logic element (10) is defined by the equation:

$$STG(n) = [NOT\ INK(n)]\ AND\ [ACT(n)\ OR\ STG(n+1)]$$

where n is an integer greater than or equal to 1, STG(n) is an output of a stage n, INK(n) is an interlock signal at stage n, ACT(n) is an actuation signal of stage n and STG(n+1) is an output signal from a stage of lower priority.

4.   A method as recited in claim 3, wherein step (d) executes the equation defining the basic logic element (10).

5.   A method as cited in claim 4, wherein step (c) includes:

(ci)  producing a logic diagram from the logic table and

(cii)  producing a logic state analysis from the logic table.

6.  A method as recited in claim 5, wherein the logic table (20) is divided into stages of different priority,, the method using totems defining different functions, wherein step (d) comprises:

(di)  overlaying (50) the input signals on the logic table;

(dii)  executing (52) the equation on each stage of the logic table from the lowest priority to the highest priority using the equation;

(diii)  repeating step (dii) for each totem; and (div)  repeating steps (di) and (dii) for a number of times equal to the number of totems plus one.

7.  A method as recited in claim 6, wherein step (di) comprises entering the input signals into the logic table at locations corresponding to the mnemonics of the signals.

FIG. I.

1/31

0209795

0209795

# FIG. 2.

| FLUID SYSTEMS ENGINEERING | I & C ENGINEERING | COMPUTER | MANUFACTURE SHOP |
|---|---|---|---|

VERBAL LOGIC REQUIREMENTS
20

SYSTEMS DESIGN
22

HARDWARE DESIGN
34

LOGIC DATA BASE
30

INTERLOCK LOGIC DIAGRAMS
31

VERIF.

ELEMENTARY WIRING DIAGRAMS
24

LOGIC STATE ANALYSIS
32

VERIF.

APPLICATION SOFTWARE
33

HAREWARE & SOFTWARE INTEGRATION
35

INTERCONNECT DRAWINGS
25

TO CUSTOMER

FINISHED SYSTEM

0209795

# FIG. 3.

| ACTUATION | PREVIOUS STAGE | INTERLOCK | ← INPUT |

ACT(n)    STG(n+1)    INK(n)

← OUTPUT

STG (n)

# FIG. 4.

| PRIORITY LEVEL | FUNCTION BLE | |
|---|---|---|
| | ACT | INK |
| 1 | ACT(n) | INK(n) |
| 2 | | |
| 3 | | |

*FIG. 5.*

*FIG. 6.*

| PRIORITY LEVEL | FUNCTION A | |
|---|---|---|
| | ACT | INK |
| 1 | ACT(1) | INK(1) |
| 2 | ACT(2) | INK(2) |
| 3 | ACT(3) | INK(3) |
| 4 | | |
| 5 | | |
| 6 | | |

# FIG. 7(A).

ACT (2)   INK (2)   INK (I)

PRIORITY LEVEL 3

18 →

12 ~ (OR)   13 NOT

PRIORITY LEVEL 2

AND ~ II

STG (2)

PRIORITY LEVEL I

12 ~ (OR)   NOT 13

17 ↗

AND ~ II

STG (I)

# FIG. 7(B).

ACT (2)   INK (2)   INK (I)

12 ~ (OR)   NOT 13

AND   II

NOT 13

AND ~ II

STG (I)

# FIG. 8.

| PRIORITY LEVEL | FUNCTION STG (I) | |
|---|---|---|
| | ACT | INK |
| I | | INK(I) |
| 2 | ACT(2) | INK(2) |
| 3 | STG(I) | |

# FIG. 9.

W AUTO MODE OPERATION

| PRIORITY LEVEL | FUNCTION B | | FUNCTION W | |
|---|---|---|---|---|
| | ACT. B | INK B | ACT. W | INK W |
| I | – | ^W | W | E |
| 2 | L | M | G | – |
| 3 | – | – | – | – |
| 4 | – | – | – | – |
| 5 | – | – | – | – |
| 6 | – | – | – | – |

## FIG. 10.

## FIG. 11.

| NO. | OUTPUTS· (T) | | INPUTS· (T) | | | | OUTPUTS· (T+1) | |
|---|---|---|---|---|---|---|---|---|
| | B | W | E | G | L | M | B | W |
| 0 | X | 0 | 0 | 0 | X | X | 0 | 0 |
| 4 | X | 0 | 0 | 1 | X | X | 0 | 0 |
| 8 | X | 0 | 1 | X | X | X | 0 | 0 |
| 16 | X | 1 | 0 | 0 | X | X | 0 | 1 |
| 18 | X | 1 | 0 | 0 | 1 | 0 | 0 | 1 |
| 19 | X | 1 | 0 | 0 | 1 | 1 | 1 | 0 |
| 24 | X | 1 | 1 | X | 0 | X | 0 | 0 |
| 26 | X | 1 | 1 | X | 1 | 0 | 1 | 0 |
| 27 | X | 1 | 1 | X | 1 | 1 | 0 | 0 |

## FIG. 12.

44

| PRIORITY LEVEL | FUNCTION W ALL ALARM SIGNALS | | FUNCTION X ALARM SIGNAL LATCHED | | FUNCTION A ACTIVATE ALARM SIGNAL | |
|---|---|---|---|---|---|---|
| | ACT. W | INK W | ACT X | INK X | ACT. A | INK A |
| 1 | E | - | W | ^F | X | - |
| 2 | F | - | X | - | T | - |
| 3 | G | - | - | - | - | - |
| 4 | H | - | - | - | - | - |
| 5 | I | - | - | - | - | - |
| 6 | - | - | - | - | - | - |

## FIG. 13.

# FIG. 14.

| NO. | OUTPUTS·(T) | | | INPUTS·(T) | | | | | | | OUTPUTS·(T+1) | | |
|---|---|---|---|---|---|---|---|---|---|---|---|---|---|
| | W | X | A | R | E | F | G | H | I | T | W | X | A |
| 0 | 0 | 0 | X | X | 0 | 0 | 0 | 0 | 0 | 0 | 0 | 0 | 0 |
| 1 | 0 | 0 | X | X | 0 | 0 | 0 | 0 | 0 | 0 | 0 | 0 | 0 |
| 2 | 0 | 0 | X | X | 0 | 0 | 0 | 0 | 0 | 0 | 0 | 0 | 0 |
| 3 | 0 | 0 | X | X | 0 | 0 | 0 | 0 | 1 | 0 | 1 | 0 | 0 |
| 4 | 0 | 0 | X | X | 0 | 0 | 0 | 1 | X | 0 | 0 | 0 | 0 |
| 5 | 0 | 0 | X | X | 0 | 0 | 0 | 1 | X | 0 | 0 | 0 | 0 |
| 8 | 0 | 0 | X | X | 0 | 0 | 1 | X | X | 0 | 0 | 0 | 0 |
| 9 | 0 | 0 | X | X | 0 | 0 | 1 | X | X | 0 | 0 | 0 | 0 |
| 16 | 0 | 0 | X | X | 0 | 1 | X | X | X | 0 | 0 | 0 | 0 |
| 17 | 0 | 0 | X | X | 0 | 1 | X | X | X | 0 | 0 | 0 | 0 |
| 32 | 0 | 0 | X | X | 1 | X | X | X | X | 0 | 0 | 0 | 0 |
| 33 | 0 | 0 | X | X | 1 | X | X | X | X | 0 | 0 | 0 | 0 |
| 256 | X | 1 | X | 0 | 0 | 0 | 0 | 0 | 0 | X | 0 | 0 | 0 |
| 258 | X | 1 | X | 0 | 0 | 0 | 0 | 0 | 1 | X | 0 | 0 | 0 |
| 260 | X | 1 | X | 0 | 0 | 0 | 0 | 1 | X | X | 0 | 0 | 0 |
| 264 | X | 1 | X | 0 | 0 | 0 | 1 | X | X | X | 0 | 0 | 0 |
| 272 | X | 1 | X | 0 | 0 | 1 | X | X | X | X | 0 | 0 | 0 |
| 288 | X | 1 | X | 0 | 1 | X | X | X | X | X | 0 | 0 | 0 |
| 320 | X | 1 | X | 1 | 0 | 0 | 0 | 0 | 0 | X | 0 | 1 | 0 |
| 322 | X | 1 | X | 1 | 0 | 0 | 0 | 0 | 1 | X | 0 | 1 | 0 |
| 324 | X | 1 | X | 1 | 0 | 0 | 0 | 1 | X | X | 0 | 1 | 0 |
| 328 | X | 1 | X | 1 | 0 | 0 | 1 | X | X | X | 0 | 1 | 0 |
| 336 | X | 1 | X | 1 | 0 | 1 | X | X | X | X | 0 | 1 | 0 |
| 352 | X | 1 | X | 1 | 1 | X | X | X | X | X | 0 | 1 | 0 |
| 512 | 1 | 0 | X | 0 | 0 | 0 | 0 | 0 | 0 | 0 | 0 | 0 | 0 |
| 513 | 1 | 0 | X | 0 | 0 | 0 | 0 | 0 | 0 | 0 | 0 | 0 | 0 |
| 514 | 1 | 0 | X | 0 | 0 | 0 | 0 | 0 | 1 | 0 | 0 | 1 | 0 |
| 515 | 1 | 0 | X | 0 | 0 | 0 | 0 | 0 | 1 | 0 | 0 | 1 | 0 |
| 516 | 1 | 0 | X | 0 | 0 | 0 | 0 | 1 | X | 0 | 0 | 0 | 0 |
| 517 | 1 | 0 | X | 0 | 0 | 0 | 0 | 1 | X | 0 | 0 | 0 | 0 |
| 520 | 1 | 0 | X | 0 | 0 | 0 | 1 | X | X | 0 | 0 | 0 | 0 |
| 521 | 1 | 0 | X | 0 | 0 | 0 | 1 | X | X | 0 | 0 | 0 | 0 |
| 528 | 1 | 0 | X | 0 | 0 | 1 | X | X | X | 0 | 0 | 0 | 0 |
| 529 | 1 | 0 | X | 0 | 0 | 1 | X | X | X | 0 | 0 | 0 | 0 |
| 544 | 1 | 0 | X | 0 | 1 | X | X | X | X | 0 | 0 | 0 | 0 |
| 545 | 1 | 0 | X | 0 | 1 | X | X | X | X | 0 | 0 | 0 | 0 |
| 576 | 1 | 0 | X | 1 | 0 | 0 | 0 | 0 | 0 | 0 | 0 | 1 | 0 |
| 577 | 1 | 0 | X | 1 | 0 | 0 | 0 | 0 | 0 | 0 | 0 | 1 | 0 |
| 578 | 1 | 0 | X | 1 | 0 | 0 | 0 | 0 | 1 | 0 | 0 | 1 | 0 |
| 579 | 1 | 0 | X | 1 | 0 | 0 | 0 | 0 | 1 | 0 | 0 | 1 | 0 |
| 580 | 1 | 0 | X | 1 | 0 | 0 | 0 | 1 | X | 0 | 0 | 0 | 0 |
| 581 | 1 | 0 | X | 1 | 0 | 0 | 0 | 1 | X | 0 | 0 | 0 | 0 |
| 584 | 1 | 0 | X | 1 | 0 | 0 | 1 | X | X | 0 | 0 | 0 | 0 |
| 585 | 1 | 0 | X | 1 | 0 | 0 | 1 | X | X | 0 | 0 | 0 | 0 |
| 592 | 1 | 0 | X | 1 | 0 | 1 | X | X | X | 0 | 0 | 0 | 0 |
| 593 | 1 | 0 | X | 1 | 0 | 1 | X | X | X | 0 | 0 | 0 | 0 |
| 608 | 1 | 0 | X | 1 | 1 | X | X | X | X | 0 | 1 | 1 | 0 |
| 609 | 1 | 0 | X | 1 | 1 | X | X | X | X | 1 | 1 | 1 | 1 |

51

## FIG. 15.

| PRIORITY LEVEL | FUNCTION W ALL ALARM SIGNALS | | FUNCTION X ALARM SIGNAL LATCHED | | FUNCTION A ACTIVATE ALARM SIGNAL | |
|---|---|---|---|---|---|---|
| | ACT W | INK W | ACT X | INK X | ACT A | INK A |
| 1 | 0 | | 0 | 1 | 0 | |
| 2 | 0 | | 0 | | 0 | |
| 3 | 0 | | | | | |
| 4 | 0 | | | | | |
| 5 | 1 | | | | | |
| 6 | | | | | | |

45

## FIG. 16.

| PRIORITY LEVEL | FUNCTION W ALL ALARM SIGNALS | | FUNCTION X ALARM SIGNAL LATCHED | | FUNCTION A ACTIVATE ALARM SIGNAL | |
|---|---|---|---|---|---|---|
| | ACT W | INK W | ACT X | INK X | ACT X | INK A |
| 1 | 0 | | 1 | 1 | 0 | |
| 2 | 0 | | 0 | | 0 | |
| 3 | 0 | | | | | |
| 4 | 0 | | | | | |
| 5 | 1 | | | | | |
| 6 | | | | | | |

46

10/31

0209795

# FIG. 17.

| PRIORITY LEVEL | FUNCTION W ALL ALARM SIGNALS | | FUNCTION X ALARM SIGNAL LATCHED | | FUNCTION A ACTIVATE ALARM SIGNAL | |
|---|---|---|---|---|---|---|
| | ACT W | INK W | ACT X | INK X | ACT A | INK A |
| 1 | 0 | | 1 | 1 | 1 | |
| 2 | 0 | | 1 | | 0 | |
| 3 | 0 | | | | | |
| 4 | 0 | | | | | |
| · 5 | 1 | | ′ | | | |
| 6 | | | | | | |

47

FIG. 18(A).

# FIG. 18(B).

0209795

# FIG. 18(C).

# FIG. 18(D).

```
                    ( 1 )
                      │
                      ▼
              ┌─────────────┐ ─120
              │    READ     /
              │  RECORD ID  /
              └─────────────┘
                      │
                      ▼
     121─┐       ╱─────────╲          ╱─────────╲  122          132
             ╱    END    ╲  YES     ╱          ╲  NO         ┌──────┐
 125        ╱  OF INPUT   ╲────────▶╲   ADD     ╱───────────▶│ STOP │
 ┌────────┐ ╲    FILE ?   ╱         ╲  RECORD? ╱             └──────┘
 │ SAVE RECORD╲         ╱            ╲        ╱
 │ IN OUTPUT │ ╲───────╱              ╲──────╱
 │   FILE    │     │ NO                  │ YES
 └────────┘       ▼                      │          133─┐
              ┌─────────┐ 123            │            ┌──────────┐
              │  READ   │                │            │ OPERATOR │
              │ RECORD  │                │            │EDIT RECORD│
              │FROM     │                │            └──────────┘
              │INPUT FILE│               │                 │
              └─────────┘                │                 ▼
                  │                       │          ┌──────────┐ ─134
          124─┐   ▼                       │          │  VERIFY  │
     NO    ╱─────────╲                    │          │  RECORD  │
 ┌────────╱   MATCH   ╲                   │          │⑥FIG.18(G).│
          ╲    ID ?   ╱                   │          └──────────┘
           ╲         ╱                    │               │
            ╲───────╱                     │          135─┐ ▼
               │ YES                       │         ╱─────────╲ YES
               ▼                           │        ╱  ERRORS   ╲───┐
     126─┐ ┌──────────┐                    │        ╲     ?     ╱
        │ DISPLAY RECORD│                  │         ╲─────────╱
        │   ON CRT     │                   │             │ NO
        └──────────┘                       │             ▼
               │                           │       ┌──────────┐ ─136
     127─┐     ▼                           │       │SAVE RECORD│
        ┌──────────┐                       │       │ IN OUTPUT │
        │MODIFY RECORD│                     │       │   FILE    │
        │DEFINITIONS │                      │       └──────────┘
        └──────────┘                        │
     128─┐     │                            │
        ┌──────────┐                        │
        │DEFINE LOGIC TABLE│────────────────┘
        └──────────┘
               │
               ▼
        ┌──────────┐ ─129
        │VERIFY RECORD│
        │⑥FIG.18(G).│
        └──────────┘
               │
    YES    ▼
 ┌─────╱─────────╲ ─130
        ╱  ERRORS   ╲
        ╲     ?     ╱
         ╲─────────╱
             │ NO
             ▼
      ┌──────────┐ ─131
      │SAVE RECORD IN│
      │OUTPUT FILE  │
      └──────────┘
             │
             ▼
          ( 3 )
```

0209795

*FIG. 18(E).*

④

SAVE CURRENT
RECORD NUMBER
M = REC. NUM. ⟋140

RESET INPUT
FILE
(POINT TO START) ⟋141

READ RECORD
FROM
INPUT FILE ⟋142

DISPLAY RECORD
NUMBER & DESCRIPTION
ON CRT ⟋143

END
OF INPUT
FILE? ⟋144   NO

YES

RESET INPUT
FILE ⟋145

MOVE TO
RECORD NUMBER
M ⟋146

READ REC.
FROM INPUT
FILE ⟋147

④

0209795

# FIG. 18(F).

(5)

SAVE CURRENT RECORD NUMBER M = REC. NUM. —150

RESET INPUT FILE FOR READ (POINT TO START) —151

READ STRING TO SEARCH FOR (CF) —152

END OF INPUT FILE? —153

NO

READ NEW RECORD FROM INPUT FILE —154

SEARCH FOR STRING —155

MATCH? —156

NO

YES

PRINT TO CRT RECORD NUMBER AND DESCRIPTION —157

YES

RESET INPUT FILE FOR READ (POINT TO START) —158

MOVE TO RECORD NUMBER M —159

READ REC. FROM INPUT FILE —160

(5)

FIG. 18(G).

# FIG. 19(A).

START ⌐200

READ FILE
NAME OPEN
IT FOR READING
N=0 ⌐201

READ
N
(MENU) ⌐202

⌐203
N=1 —YES→ SUMMARY OF RECORDS ① FIG. 19(B). ⌐204

NO↓

⌐205
N=2 —YES→ FIND RECORD ② FIG. 19(C). ⌐206

NO↓

⌐207
N=3 —YES→ DRAW LOGIC DIAGRAM ③ FIG. 19(D). ⌐208

NO↓

⌐209
N=4 —YES→ EXIT PROGRAM CLOSE FILE ⌐210 → STOP

NO

# FIG. 19(B).

# FIG. 19(C).

0209795

**FIG. 19(D).**

(3)

ENTER RECORD NUMBER TO DRAW LOGIC (N) ─ 250 ◀── (CI)

RETRIVE RECORD NUMBER N FROM INPUT FILE ─ 251

SCAN RECORD ─ 252

MORE THEN TWO TOTEMS ? ─ 253

NO / YES

SET LP TO 80 CHARACT./LINE SET SCALE=1 ─ 254

SET LP TO 132 CHARACT./LINE SET SCALE = 1/2 ─ 255

PRINT HEADER TOP LABLE TO LP ─ 256

DRAW TOTEMS SAVE IN GRAPH (4) FIG. 19(E). ─ 257

CONNECT TOTEMS SAVE IN GRAPH (5) FIG. 19(F). ─ 258

PRINT GRAPH TO LP ─ 259

PRINT ON LP BOTTOM LABLE & SIGNAL DEFINITIONS ─ 260

RESET PRINTER & INPUT FILE ─ 261

(3)

FIG. 19(E).

# FIG. 19(F).

(5)

T=1 ~290

N=1 ~291

y=NSTG ~292

STG(T)=ACT$_N$(y) ? ~293

YES → DRAW CONNECTION BETWEEN OUTPUT OF TOTEM T AND ACT (y) IN TOTEM N ~294

NO

T=N ? ~295

NO → STG(T)=INK$_N$(y) ? ~296

YES → DRAW CONNECTION BETWEEN OUTPUT OF TOTEM T AND INTERLOCK(y) IN TOTEM N ~297

NO

YES

y=y-1 ~298

y=0 ? ~299

NO

YES

N=N+1 ~300

N>MAX ? ~301

NO

YES

T=T+1 ~302

T>MAX ? ~303

NO

YES

(5)

# FIG. 20(A).

START — 310

READ FILE
NAME OPEN
IT FOR READING
N=0 — 311

READ
N
(MENU) — 312

N=1 — 313
YES → SUMMARY OF RECORDS ① FIG. 20(B). — 314
NO

N=2 — 315
YES → FIND RECORD ② FIG. 20(C) — 316
NO

N=3 — 317
YES → TEST LOGIC ③ FIG. 20(D) — 318
NO

N=4 — 319
YES → EXIT PROGRAM CLOSE FILE — 320 → STOP
NO

# FIG. 20(B).

# FIG. 20(C).

# FIG. 20(D).

③

ENTER RECORD NUMBER TO TEST LOGIC  ~350  ── Cl·

READ (N)  ~351

RETRIVE RECORD NUM. (N) FROM INPUT FILE  ~352

SET INPUT/OUTPUT LABLES PRINT REC. HEADER TO CRT AND ·LP·  ~353

CALCULATE MAX NUMBER OF LOGIC STATES MAX MAX= 2 (NO. OF INPUTS + NO. OF OUTPUTS)  ~354

CLEAR INP/OUT STATE AND LOGIC TABLE I=0  ~355

UPDATE INPUT STATE AND TABLE I=I+1  ~356

CALCULATE BOOLEAN VARIABLE IN TABLE

SET OUTPUT STATE VECTOR AND SAVE IN LOGIC TABLE SEE FIG. 21(B).  ~357

NO ◇ I=MAX ? ~358

YES

REDUCE LOGIC TABLE ④ FIG. 20(E).  ~359

PRINT REPORT ON ·LP·  ~360

③

# FIG. 20(E).

# FIG. 21(A).

INITIALIZE INPUT STATE VECTOR — 380

SAMPLE INPUT SIGNALS — 381

GENERATE INPUT STATE VECTOR (INPUTS AND OUTPUTS) — 382

N=0 — 383

UPDATE LOGIC TABLE (OVERLAY STATE VECTOR ON TABLE) — 384

UPDATE STATE VECTOR — 388

CALCULATE ALL TOTEMS (OUTPUTS) ① FIG. 21(B). — 385

N=N+1 — 386

N > TMAX+1 ? — 387

NO

YES

UPDATE OUTPUT STATE — 389

SEND OUTPUT TO I/O PORT — 390

0209795

## FIG. 21(B).

```
                    ( I )
                      |
         +-----------------------+
         |         I=1           |
         |- - - - - - - - - - - -|---- 400
         |    SELECT TOTEM       |
         |      NUMBER I         |
         +-----------------------+
                      |
    +---------------->|
    |    +---------------------------------+
    |    |     STAGE (SMAX+1)=FALSE        |---- 401
    |    |- - - - - - - - - - - - - - - - -|
    |    |    INITIALIZE VARIABLE STAGE    |
    |    |(SMAX=NUMBER OF STAGES IN A TOTEM)|
    |    +---------------------------------+
    |                 |
    |    +---------------------------------+
    |    |          J=SMAX                 |---- 402
    |    |- - - - - - - - - - - - - - - - -|
    |    |  SET y TO NUM. OF STAGES IN THE TOTEM |
    |    +---------------------------------+
    |                 |
    |  +------------->|
    |  |  +---------------------------------+
    |  |  |       ACT(N)=B_ACT(y)           |
    |  |  |- - - - - - - - - - - - - - - - -|---- 403
    |  |  |      GET LOGIC VALUE OF         |
    |  |  |    ACTUATION (y) IN TOTEM I     |
    |  |  |     FROM BOOLEAN TABLE AND      |
    |  |  |   ASSIGN IT TO VARIABLE AK      |
    |  |  +---------------------------------+
    |  |                 |
    |  |  +---------------------------------+
    |  |  |          IK= B_INK(y)           |---- 404
    |  |  |- - - - - - - - - - - - - - - - -|
    |  |  | GET LOGIC VALUE OF INTERLOCK (y) IN TOTEM I |
    |  |  |FROM BOOLEAN TABLE AND ASSIGN IT TO LOGIC VARIABLE IK|
    |  |  +---------------------------------+
    |  |                 |
    |  |  +---------------------------------+
    |  |  |STG(N)=[NOT INK(N)] AND [ACT(N) OR STG(y+1)]|---- 405
    |  |  |- - - - - - - - - - - - - - - - -|
    |  |  |   CALCULATE LOGIC VALUE OF STAGE (y)|
    |  |  +---------------------------------+
    |  |                 |
    |  |            +---------+
    |  |            |  y=y-1  |---- 406
    |  |            +---------+
    |  |                 |
    |  |      NO      / y=1 ? \---- 407
    |  +-----------< >
    |                 \       /
    |                  YES
    |                   |
 +---------+    +---------------------------------+
 |  I=I+1  |    |       OUTPUT(I)=STG(y)          |---- 408
 |---------|410 |- - - - - - - - - - - - - - - - -|
 |SELECT NEXT TOTEM| |  PUT LOGIC VALUE OF STAGE (I) TO |
 +---------+    | OUTPUT OF TOTEM I (OUTPUT VECTOR)|
    |           +---------------------------------+
    |                          |
    |      NO          / I=TMAX ? \---- 409
    +---------------< >
                      \         /
                       YES
                        |
                      ( I )
```